# EUROPEAN PATENT APPLICATION

(11) **EP 4 822 651 A1**
(43) Date of publication of application: **14.10.2026**
(21) Application number: 25748335.4
(22) Date of filing: 16.01.2025
(51) Int. Cl.: G06T 19/00, E02F 9/22, E02F 9/26, G06F 3/04815, G06F 3/04845, G06T 19/20, G09B 9/00, G09B 19/00

(54) **WORK SITE SIMULATION SYSTEM**

(30) Priority: 31.01.2024 JP 2024012559; 31.01.2024 JP 2024012560
(71) Applicant: KOBELCO CONSTRUCTION MACHINERY CO., LTD., Hiroshima-shi, Hiroshima 731-5161 (JP)
(72) Inventor: SHIMAZU, Yasuhiko, Saeki-ku, Hiroshima-shi Hiroshima 731-5161 (JP); SEKIZUKA, Ryota, Saeki-ku, Hiroshima-shi Hiroshima 731-5161 (JP)
(74) Representative: TBK
(86) International application number: PCT/JP2025/001217
(87) International publication number: WO 2025/164338

(57) **Abstract**

Provided is a work site simulation system including a computer (20). The computer (20) sets an area of a part of a site model (M11), which is shape information about a work site S, as a selection area, and converts the site model (M11) into a changeable model (M15) in the selection area. The changeable model (M15) is shape information on which change processing by the computer (20) is allowed. The change processing includes at least one of deformation, movement, addition, and removal. The computer (20) restricts the change processing on the site model (M11) more than the change processing that is allowed to be performed on the changeable model (M15).

## Description

### Technical Field

The present invention relates to a work site simulation system that simulates a work site in a virtual space.

### Background Art

Patent Literature 1 describes executing simulation of a motion of an excavator as a work machine in a virtual environment.

The performance of the simulation, however, involves a large computation load to be applied on the computer.

### Citation List

### Patent Literature

Patent Literature 1: WO 2021/241716

### Summary of Invention

It is an object of the present invention to provide a work site simulation system including a computer that simulates a motion of a work machine at a work site in a virtual space, the system allowing a computation load on the computer for performing the simulation to be reduced.

Provided is a work site simulation system, including a computer that simulates a motion of a work machine at a work site in a virtual space. The computer is configured to perform acquiring a site model that is shape information about a shape of the work site, setting an area of a part of the site model as a selection area, and converting the site model into a changeable model in the selection area, wherein the changeable model is shape information that allows change processing, which is at least one of deformation, movement, addition, and removal, to be performed by the computer. The computer is configured to restrict the change processing on the site model more than the change processing that is allowed to be performed on the changeable model. The scope of the restriction of the change processing on the site model encompasses prohibiting any of the change processing allowed to be performed on the changeable model from being performed on the site model.

### Brief Description of Drawings

FIG. 1 is a block diagram showing a work site simulation system according to an embodiment of the present invention.
FIG. 2 is a block diagram of a model conversion processing part included in the work site simulation system.
FIG. 3 is a flowchart showing a flow of processing to be executed by a computer included in the work site simulation system.
FIG. 4 is a perspective view showing an image of a work site viewed obliquely from above, the work site simulated in a virtual space by the work site simulation system.
FIG. 5 is a diagram showing an image of a selection area and the like viewed obliquely from above, the selection area set in the site model of the work site.
FIG. 6A is a plan view showing a site model in the selection area in the image and a changeable model converted from the site model.
FIG. 6B is a diagram showing a plurality of meshes constituting the changeable model.
FIG. 7 is a diagram showing vertices Vpg of a plurality of polygons and the like in the site model.
FIG. 8 is a diagram showing an image to be displayed in a construction plan mode by a display unit included in the work site simulation system.
FIG. 9 is a perspective view showing an image of a physical calculation area and the like viewed obliquely from above, the physical calculation area set in the changeable model shown in FIG. 8.
FIG. 10 is a diagram showing an image to be displayed by the display unit in an operator operation mode, the image being an image of the work site viewed from the inside of the operation chamber shown in FIG. 9, the image showing a state before excavation by the bucket.
FIG. 11 is a diagram showing an image of a state of the bucket excavating sediment in a crowding direction, the state viewed from an operation chamber of the work machine in the virtual space.
FIG. 12 is a diagram showing an image of a work site viewed obliquely from above, in which site sediment has been excavated.
FIG. 13 is a diagram showing an image of a state where the upper turning body of the working machine has been turned from the state shown in FIG. 12, the state viewed obliquely from above.
FIG. 14 is a diagram showing an image of a state of sediment being discharged from the bucket, the state viewed from the operation chamber.
FIG. 15 is a diagram showing an image of a state of the bucket excavating the sediment in a turning direction, the state viewed obliquely from above.
FIG. 16 is a diagram showing an image of a state of the bucket excavating sediment in a dump direction, the state viewed obliquely from above.
FIG. 17 is a side view of the work site shown in FIG. 4.

### Description of Embodiment

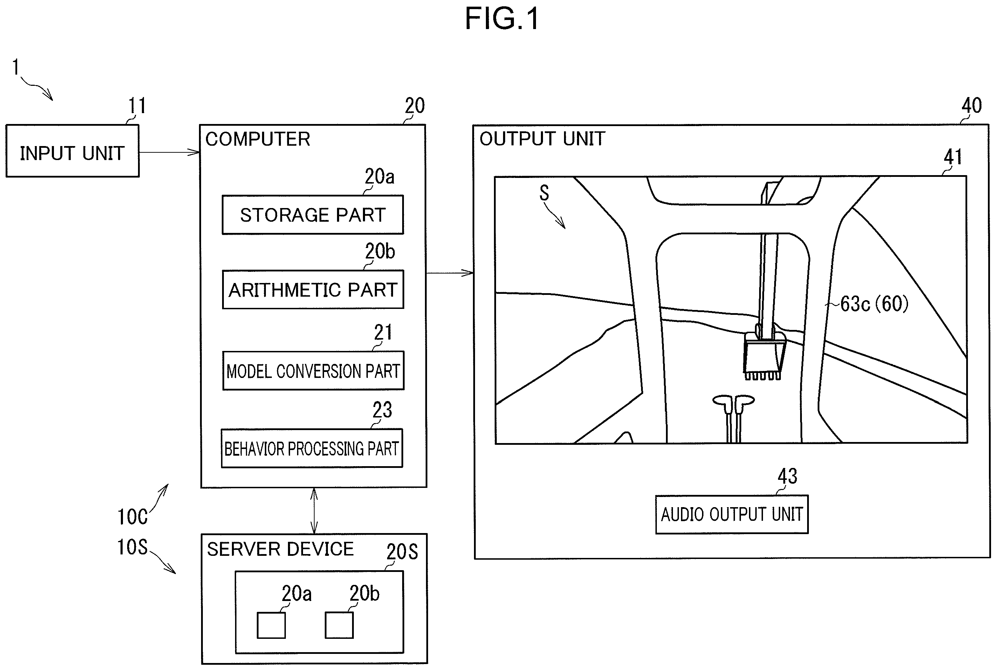

Preferred embodiments of the present invention will be described with reference to FIGS. 1 to 17.

FIG. 1 shows a work site simulation system 1 according to the embodiment. The work site simulation system 1 is a system that simulates a work site S shown in FIG. 1 in a virtual space. The work site simulation system 1 simulates at least the motion of a work machine 60 at the work site S. The work site simulation system 1 may further simulate the state (movement, etc.) of an object 50 other than the work machine 60. The work site simulation system 1 includes, for example, at least one of a personal computer, a tablet, and a smartphone. The work site simulation system 1 according to the embodiment includes a remote operation device that remotely operates a real work machine, that is, an actual machine corresponding to a work machine 60 in the below-described virtual space.

The work site simulation system 1 can be used for various applications. For example, the work site simulation system 1 may be used to set up a construction plan that is a plan for work at a real work site. The work site simulation system 1 may be used to make a plan regarding a real work machine at a real work site. The work site simulation system 1 may be used as an operation simulation apparatus for simulating an operation of a real work machine. Specifically, the work site simulation system 1 may be used as a practice device for enabling a user to learn an operation (boarding operation or remote operation) on a real work machine, for example, a training device or a teaching device. This enables the user to operate a work machine 60 in a virtual space to thereby learn the operation of the real work machine efficiently to master the operation. The work site simulation system 1 may be used as a motion verification device for verifying the motion (behavior) of the work machine 60. The work site simulation system 1 may be used as a situation verification device for verifying various situations at the work site S other than the motion of the work machine 60. The work site simulation system 1 may be used to reproduce the motion of the real work machine in the virtual space based on the operation data about the real work machine, that is, to perform digital twin.

The work site simulation system 1 shown in FIG. 1 includes a client device 10C and a server device 10S. The client device 10C includes an input unit 11, a computer 20, and an output unit 40, and the server device 10S includes a computer 20S.

Each of the client device 10C and the server device 10S includes a computer. The server device 10S operates in accordance with a command that is input from the client device 10C. The function of the work site simulation system 1 is implemented by the client device 10C and the server device 10S. At least one of the input unit 11 and the output unit 40 may be included either in the server device 10S or in both of the client device 10C and the server device 10S. Each of the computers 20 and 20S includes a storage part 20a and an arithmetic part 20b. One of the computers 20 and 20S may be omitted. The work site simulation system 1 may include either only a single client device 10C or a plurality of client devices 10C. Similarly, the work site simulation system 1 may include either only a single server device 10S or a plurality of server devices 10S. The client device 10C and the server device 10S may be connected to each other through either wireless communication or wired communication. According to the embodiment, the exchange of information between the client device 10C and the server device 10S is performed by a communication means such as a mobile phone line, an optical line, a wireless LAN (Local Area Network), or a wired LAN. The work site simulation system 1 is also configurable without the server device 10S.

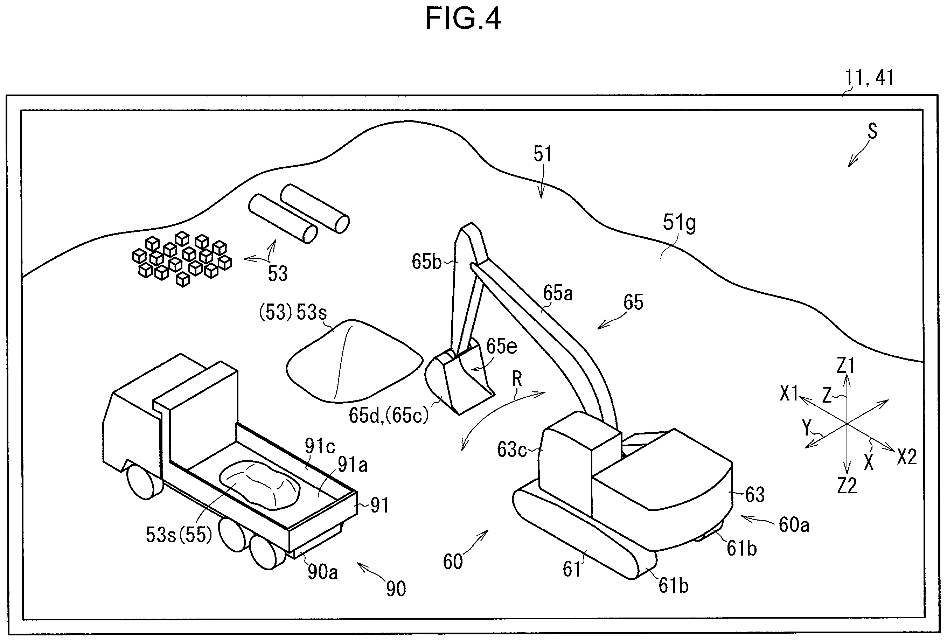

The input unit 11 is a device for inputting information to the computer 20. The input unit 11 allows an operation for inputting the information to be applied to the input unit 11 by a user (operator, worker) of the work site simulation system 1. To the input unit 11 may be applied an operation for moving the work machine 60 in the virtual space. For example, to the input unit 11 may be applied either an operation for instructing the start and end of the motion of the work machine 60 or an operation for causing the motion of the work machine 60, for example, the traveling of the lower main body 61 shown in FIG. 4, the turning of the upper turning body 63 shown in FIG. 4, and the motion of the work device. To the input unit 11 may be applied an operation onto a GUI (Graphical User Interface) for a user to perform an operation in the work site simulation system 1. To the input unit 11 may be applied an operation other than the above-described operation. The input unit 11 includes, for example, at least one of a mouse, a keyboard, a touch panel, and a game pad. The input unit 11, alternatively, may include a lever and a pedal imitating an operation member included in a real work machine, for example, left and right operation levers, and left and right operation pedals (foot pedals). The input unit 11 may be included in the remote operation device. The input unit 11 may be configured to input information to the computer 20 regardless of an operation applied by a user.

The computer 20 performs input/output of a signal, calculation, storage of information, and the like. The computer 20 simulates the work site S in the virtual space. The computer 20 has a plurality of functions, which are implemented through the execution of a work site simulation program stored in the storage part 20a by the arithmetic part 20b. The computer 20 and other devices (for example, the input unit 11 and the output unit 40) may be interconnected through either wireless communication or wired communication. Specifically, there may be applied communication similar to communication for interconnection of the client device 10C and the server device 10S. To the computer 20 is input the information from the input unit 11. The computer 20 inputs a command to the output unit 40.

In the storage part 20a is stored information. In the storage part 20a is stored a program.

The arithmetic part 20b performs arithmetic operation, specifically, calculation, judgment, and the like.

The plurality of functions include a model conversion processing part 21 and a behavior processing part 23 shown in FIG. 1.

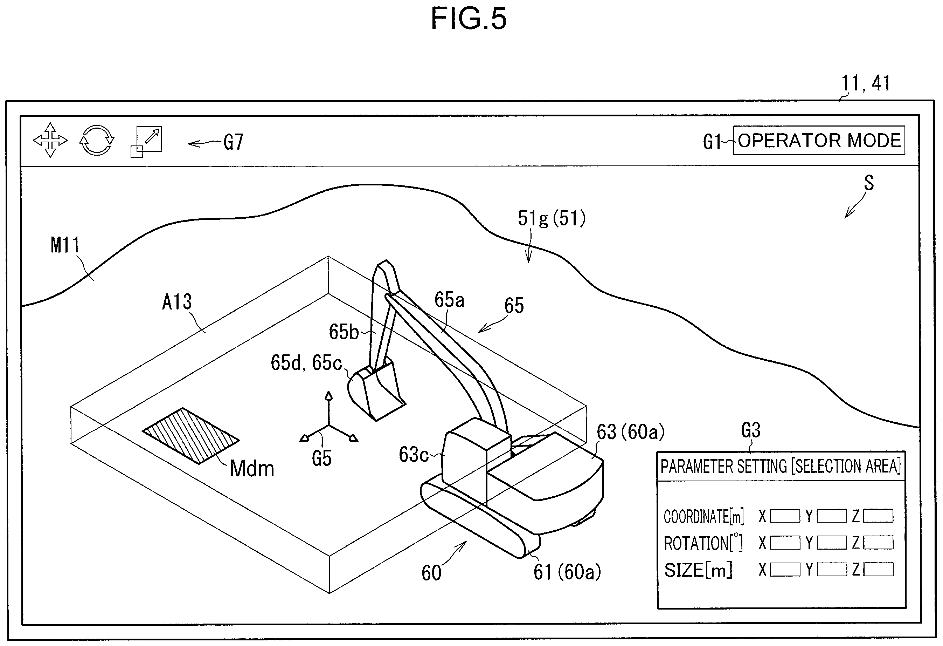

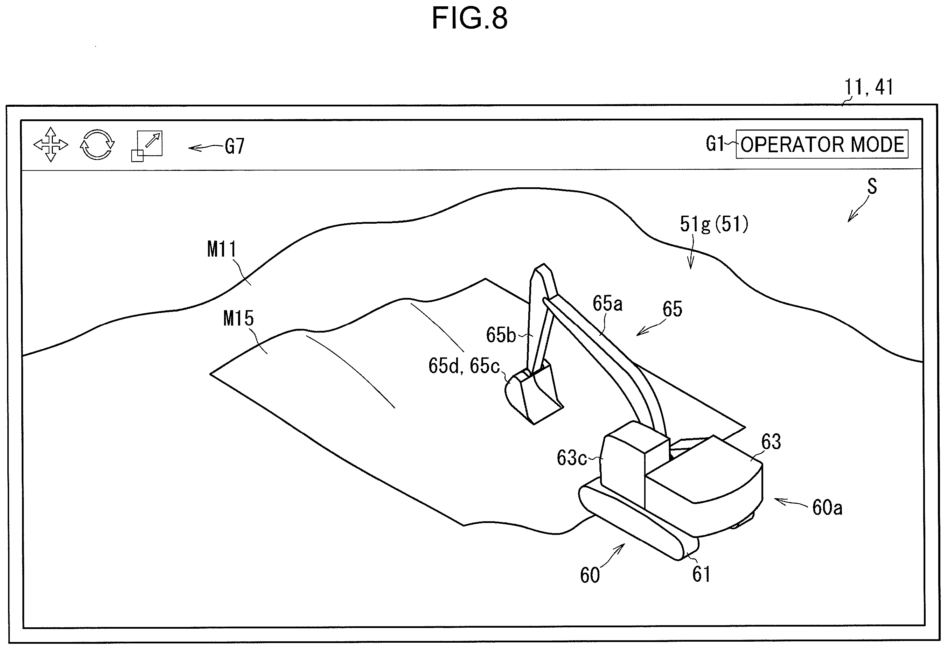

The model conversion processing part 21 is a data conversion part that performs model conversion processing. As will be described in detail later, the model conversion processing is processing of converting a site model M11 shown in FIG. 5 into a changeable model M15 shown in FIG. 8. The site model M11 is, for example, shape information about the shape of the work site S as shown in FIG. 5, and the changeable model M15 is shape information that is information about shape and allows change processing including at least one of deformation, movement, addition, and removal to be performed on the changeable model M15 by the computer 20.

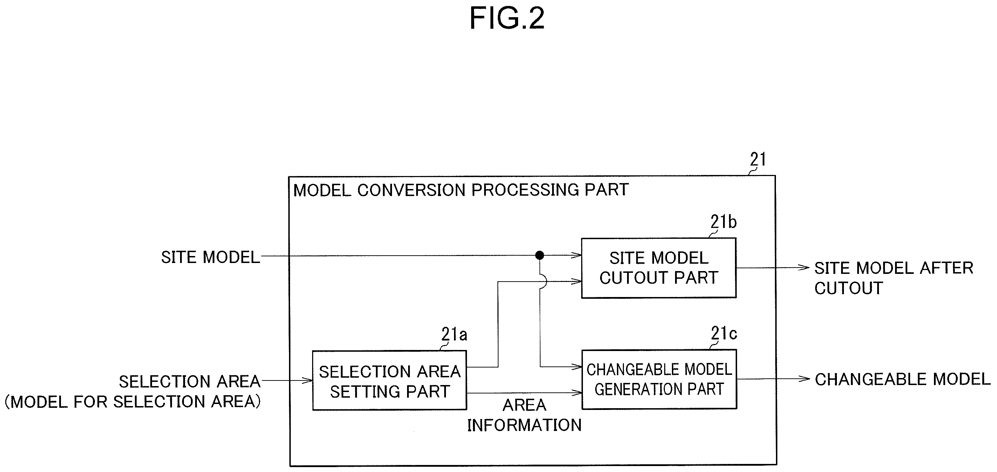

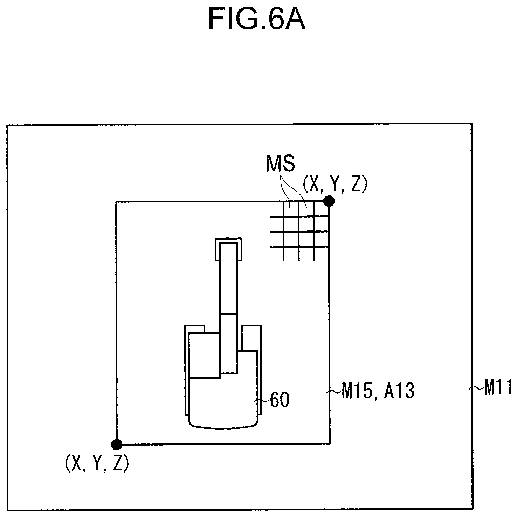

As shown in FIG. 2, the model conversion processing part 21 includes a selection area setting part 21a, a site model cutout part 21b, and a changeable model generation part 21c. As will be described in detail later, the selection area setting part 21a sets a selection area A13 shown in FIG. 5, which is an area in which the conversion from the site model M11 to the changeable model M15 is to be performed. The site model cutout part 21b performs processing of cutting out, i.e., removing, the part corresponding to the selection area A13 from the site model M11 shown in FIG. 6A. The changeable model generation part 21c performs processing of generating the changeable model M15 in place of the part that is cut out from the selection area A13 by the site model cutout part 21b.

The behavior processing part 23 performs behavior processing, which is processing related to a behavior of the object 50 in the virtual space shown in FIG. 1. The behavior processing part 23 calculates a behavior which the object 50 is to be made perform in the virtual space, the behavior being a behavior by which the behavior of a real object is simulated (reproduced).

The output unit 40 is capable of outputting information. The output unit 40 performs output in accordance with a command input from the computer 20. The output unit 40 outputs information on a phenomenon in the virtual space.

The output unit 40 includes a display unit 41 and an audio output unit 43.

The display unit 41 performs display in accordance with a command input from the computer 20. The display unit 41 displays an image (video) of the virtual space calculated by the computer 20. The display unit 41 may display the result of a calculation by the computer 20. The display unit 41 may display a GUI. The display unit 41 includes a monitor (screen). The display unit 41 according to the present embodiment includes a monitor of the remote operation device as described later.

The audio output unit 43 outputs a sound (output sound) in accordance with a command input from the computer 20. The audio output unit 43 includes a speaker. The audio output unit 43 may include a speaker of the remote operation device.

At least a part of the work site simulation system 1 may be installed on the remote operation device. Specifically, the input unit 11 may include a device (an operation lever, an operation pedal, a switch, or the like) for inputting information to the remote operation device. The input unit 11, if configured to enable remote operation of an actual machine to be performed and used for an operation to move the work machine 60 in the virtual space, enables a user to operate the work machine 60 in the virtual space to thereby feel an operation feeling similar to the operation feeling of the actual machine, thereby, for example, enabling the skill of the operation of the remote operation device to be promoted to be mastered by the user. Similarly, the computer 20 may include a part forming a part of the remote operation device. In this case, the computer 20 exchanges signals with the actual machine, which is the target of the remote operation, through the communication means. Specifically, the computer 20 transmits an operation command signal, which is a signal for moving the actual machine, to the actual machine based on the operation signal that is input from the input unit 11. Besides, the computer 20 receives, through the communication means, a signal output by a sensor mounted on the actual machine, for example, image data of a camera mounted on an actual machine, audio data of a microphone mounted on an actual machine, and the like. The output unit 40 may include a device for outputting information from the remote operation device. For example, when being a monitor of the remote operation device, the display unit 41 displays image data acquired by a camera mounted on the actual machine. For example, when being a speaker of a remote operation device, the audio output unit 43 outputs audio data acquired by a microphone mounted on the actual machine.

In a case where the work machine 60 in the virtual space is configured to be operated (specifically, has an operator operation mode to be described later) and the output unit 40 includes a device for output from the remote operation device, the user can perform the operation on the work machine 60 in the virtual space while perceiving an output similar to the output (display, sound) from the output unit 40, the output being information to be perceived (viewed and listened to) when remotely operating the actual machine. In this case, the output unit 40 can be also used as a device for output from the remote operation device. This eliminates the necessity of preparing a device (monitor or the like) other than the device for output from the remote operation apparatus as the output unit 40 of the work site simulation system 1. Besides, when configured to allow the work machine 60 in the virtual space to be operated (that is, has an operator operation mode to be described later) with both the input unit 11 and the output unit 40 configured to be able to be also used for remote operation of an actual machine, the work site simulation system 1 enables the user to experience a sense closer to an operation sense in the actual machine in comparison with a case where only one of the input unit 11 and the output unit 40 is used for remote operation of an actual machine.

As shown in FIG. 4, the computer 20 sets the work site S and the plurality of objects 50 in the virtual space.

The work site S is a place where the work machine 60 performs motions for work or the like in the virtual space. The following description is made, in principle, for an event in the virtual space. For example, the motion of the work machine 60 means, in principle, the motion of the work machine 60 in the virtual space.

Each of the plurality of objects 50 is produced by simulating, that is, modeling, an object at a real work site. Each of the objects 50 is a three-dimensional model. The plurality of objects 50 illustrated in FIG. 4 include a ground 51, a work object 53, an object-in-container 55, a work machine 60, and a vehicle 90.

The ground 51 is the ground of the work site S. The ground 51 illustrated in FIG. 8 includes a flat ground, an inclined surface, irregularities, and the like. The ground 51 includes a ground surface 51g, which is the surface of the ground 51.

The work object 53 is an object of work to be performed by the work machine 60. The work object 53 may be either of sediment 53s illustrated in FIG. 4, a rock, a magnetic material attractable by a magnet, such as a metal, a resin, a waste, a wood such as a log, or a structure such as a block. The sediment 53s includes at least one of soil, sand, and gravel. The shape of the work object 53 is variously settable. The work object 53 may be either one formed by a surface having information on a height or one produced by simulating the sediment 53s that forms the ground surface 51g. The work object 53 may be one having a rectangular parallelepiped shape or a substantially rectangular parallelepiped shape, for example, either a simulated object attractable by a magnet or a simulated structure such as a block. The work object 53, alternatively, may be one having a cylindrical shape or a substantially columnar shape, for example, either a simulated log or a simulated structure such as a column.

The object-in-container 55 is an object 50 that is contained in a container. Examples of the container include a bucket 65d of the work machine 60 and a loading platform 91 of the vehicle 90 shown in FIG. 4. In the example shown in FIG. 4, the object-in-container 55 is the work object 53. The object-in-container 55 may be an object other than the work object 53.

The work machine 60 is a machine that performs work. The work machine 60 may be either a construction machine that performs construction work or a cargo handling machine that performs cargo handling work. Examples of the work machine 60 include an excavator, a crane, a bulldozer, and a wheel loader.

The work machine 60 includes a machine body 60a and a plurality of work devices.

The machine body 60a is the main body of the work machine 60. The machine body 60a includes the lower main body 61 and the upper turning body 63.

The lower main body 61 supports the upper turning body 63 on the lower side of the upper turning body 63. The lower main body 61 illustrated in FIG. 4 is a lower traveling body capable of traveling on a traveling surface (e.g., the ground surface 51g). The lower main body 61 is also allowable to be incapable of traveling.

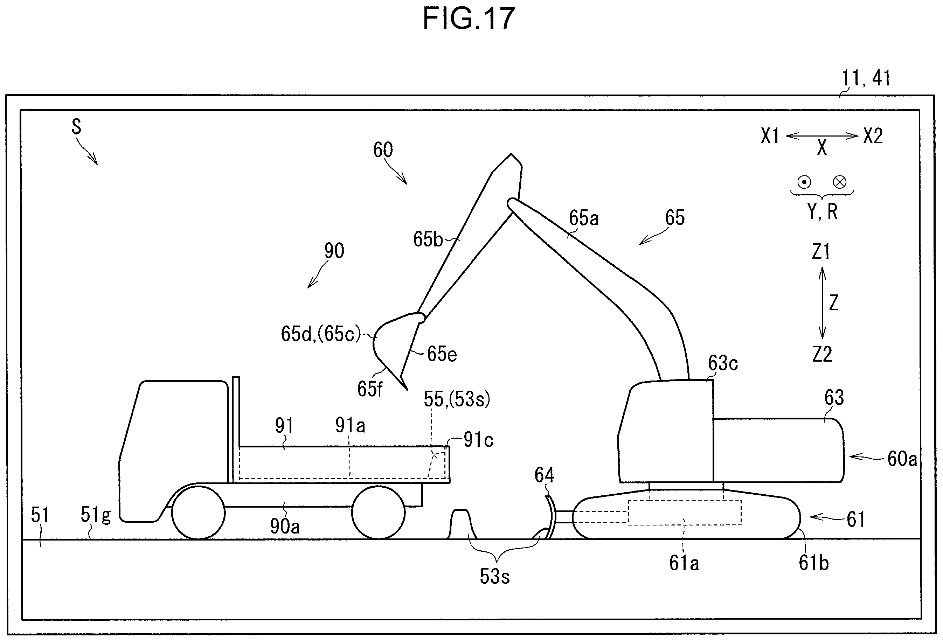

The lower main body 61 includes a lower frame 61a and a pair of left and right traveling units 61b, which are illustrated in FIG. 17.

The lower frame 61a is a frame (structure) that supports the pair of traveling units 61b. Each of the pair of traveling units 61b includes a movable part with respect to the lower frame 61a, specifically, a part capable of performing a traveling motion that is a motion for traveling. Each of the pair of traveling units 61b may include either a crawler or a plurality of wheels. The pair of traveling units 61b are disposed on both sides of the lower main body 61 in the width direction, i.e., the left-right direction.

The upper turning body 63 is mounted on the lower main body 61 so as to be capable of turning with respect to the lower main body 61. The upper turning body 63 includes a not-graphically-shown turning frame and an operation chamber 63c disposed on the turning frame.

The work machine 60 has a machine vertical direction Z, an upper-turning-body front-rear direction X, an upper-turning-body lateral direction Y, and a turning direction R. The machine vertical direction Z is a direction in which a turning axis that is the center axis of the turning motion of the upper turning body 63 with respect to the lower main body 61 extends. The machine vertical direction Z includes a machine upward direction Z1 that is a direction from the lower main body 61 toward the upper turning body 63, and a machine downward direction Z2 reverse to the machine upward direction Z1. The upper-turning-body front-rear direction X is a direction orthogonal to the machine vertical direction Z, being a direction in which the attachment 65 moves with respect to the upper turning body 63. The upper-turning-body front-rear direction X includes an upper-turning-body frontward direction X1 in which the operation chamber 63c faces and an upper-turning-body rearward direction X2 opposite to the upper-turning-body frontward direction X1. The upper-turning-body lateral direction Y is a direction orthogonal to each of the machine vertical direction Z and the upper-turning-body front-rear direction X, being a direction in which a rotation center axis, which is the center axis of the rotational movement of the attachment 65 described later, extends. The turning direction R is the direction of the turning motion of the upper turning body 63 with respect to the lower main body 61. The bottom surface of the work machine 60 may be inclined to the horizontal direction in the virtual space. The upper-turning-body front-rear direction X and the upper-turning-body lateral direction Y, therefore, is not always coincident with the horizontal direction in the virtual space, and the machine vertical direction Z is not always coincident with the vertical direction in the virtual space. The following description, however, is made based on the state where the machine vertical direction Z is coincident with the vertical direction in the virtual space.

The operation chamber 63c is a part where an operator can perform an operation in a real work machine. The operation chamber 63c may be either one fixed to the turning frame of the upper turning body 63 or movable one capable of relative movement to the turning frame. The relative movement includes, for example, at least one of translation along the machine vertical direction Z and rotational movement in the machine vertical direction Z. Specifically, if being the movable one, the operation chamber 63c may be either of an elevator cab, a link cab, and a tilt cab. In the case of being the elevator cab, the operation chamber 63c is movable relative to the turning frame of the upper turning body 63 in the machine vertical direction Z. In the case of being the link cab, the operation chamber 63c is connected to the turning frame of the upper turning body 63 via a link mechanism, which makes actions to allow the operation chamber 63c to move in the machine vertical direction Z and the upper turning body front-rear direction X with respect to the turning frame. In the case of being the tilt cab, the operation chamber 63c is rotationally movable in the machine vertical direction Z about a rotation axis extending in the upper-turning-body lateral direction Y with respect to the turning frame of the upper turning body 63, that is, tiltable.

The plurality of work devices include a dozer 64 and the attachment 65. Each of the work devices is configured to perform a work motion for a specific work on the work object 53 (for example, work for moving the work object 53).

Specifically, the dozer 64 includes a plate-like member (for example, an earth removal plate) extending in the width direction of the lower main body 61 and the machine vertical direction Z, attached to the lower frame 61a as shown in FIG. 17. The dozer 64 may be attached so as to be relatively movable to the lower frame 61a in the machine vertical direction Z.

The attachment 65 is attached to the upper turning body 63 to turn together with the upper turning body 63. The attachment 65 illustrated in FIG. 4 includes a boom 65a, an arm 65b, and a tip attachment 65c. The boom 65a is connected to the upper turning body 63 so as to be raiseable and lowerable with respect to the upper turning body 63, specifically, rotationally movable in the machine vertical direction Z. The arm 65b is connected to the boom 65a so as to be rotationally movable in the machine vertical direction Z with respect to the boom 65a. The tip attachment 65c is connected to the arm 65b so as to be rotationally movable in the machine vertical direction Z with respect to the arm 65b. The tip attachment 65c forms the distal end part of the attachment 65. The tip attachment 65c is capable of capturing (holding) and releasing the work object 53. The tip attachment 65c illustrated in FIG. 4 is the bucket 65d. The tip attachment 65c, alternatively, may be either one of a magnet that attracts the work object 53 by magnetic force, a device that sandwiches the work object 53 (grapple, nibra, rotary fork, etc.), and a device that crushes the work object 53 (breaker or the like). The device that sandwiches the work object 53 (e.g., a rotary fork) includes an arm connection part to be connected to the arm 65b and a sandwiching part to sandwich the work object 53, the sandwiching part configured to make relative rotation to the arm connection part to thereby allow the direction in which the sandwiching part sandwiches the work object 53, namely, an opening/closing direction, to be easily changed. The opening/closing direction may be changeable to, for example, either the upper-turning-body front-rear direction X or the upper-turning-body lateral direction Y.

The bucket 65d has a shape capable of serving as the container for holding (accommodating) the work object 53, being capable of performing work for scooping the work object 53, work for excavating the work object 53, and the like.

Specifically, as shown in FIG. 17, the bucket 65d has a bucket opening surface 65e and a bucket tip back surface 65f. The bucket opening surface 65e is a surface including an opening formed by the bucket 65d, allowing the discharge of the work object 53 from the bucket 65d and the entry of the work object 53 into the bucket 65d to be performed through the opening. The bucket tip back surface 65f forms a tip part of the bucket 65d, that is, a part on the side opposite to the distal end of the arm 65b, having, for example, a planar shape.

The work machine 60 is set so as to make a motion in the virtual space, examples of the motion including the traveling motion of the lower main body 61, the turning motion of the upper turning body 63, and the motion of the work device, for example, the motion by which the attachment 65 changes its posture. The work machine 60 may be moved either based on information prestored in the computer 20 or in accordance with a manual operation performed by a user, for example, in the below-described operator operation mode. It is also allowable that there are set a plurality of work machines 60 in the virtual space to allow a work machine 60 to be selected from among the plurality of work machines 60 as the target of the manual operation by a user.

The vehicle 90 includes the loading platform 91 that serves as the container and a vehicle body 90a that supports the loading platform 91. As shown in FIG. 4, the vehicle 90 is a transport vehicle capable of carrying an accommodation object (for example, the work object 53) accommodated in the loading platform 91, for example, being a dump truck.

In the example shown in FIG. 4, the loading platform 91 serving as the container has a box shape opened upward. Specifically, the loading platform 91 includes a loading-platform bottom 91a and a loading-platform enclosure 91c. The platform bottom 91a is the bottom (floor) of the loading platform 91. The loading-platform enclosure 91c protrudes upward from the peripheral edge of the loading-platform bottom 91a so as to enclose the space over the platform bottom 91a.

At least a part of the specifications of the container including the loading platform 91, for example, at least a part of the position, dimension, and shape of the loading platform 91, is variously settable. For example, the information on the loading platform 91 may be either stored in advance in the computer 20 or set based on information about specifications of the vehicle 90 stored in advance in the computer 20. The information on the loading platform 91, alternatively, may be either arbitrarily set in accordance with a manual operation by a user, specifically, an operation applied to the input unit 11 shown in FIG. 1, or stored in advance to be changeable in accordance with the manual operation. The information of the loading platform 91, alternatively, may be set based on a numerical value (indicating a position, a dimension, or the like) input to the computer 20. The same applies to the selection area A 13 which is set based on the numerical value as described later. For example, the information about the loading platform 91 may be set based on either numerical values indicating respective coordinates of the positions of the vertices of the outer shape of the loading platform 91 in a plan view, for example, the four corners of the loading-platform bottom 91a or a numerical value indicating the height of the loading-platform enclosure 91c. The information on the loading platform 91 may be set or changed based on an operation applied to the below-described area change part G5 or a part similar to the area change part G5, shown in FIG. 5.

The plurality of objects 50 are not limited to those described above. For example, the plurality of objects 50 may include either a container different from either the loading platform 91 or the bucket 65d, for example, a container placed on the ground surface 51g, or a hole dug in the ground surface 51g to accommodate the work object 53, for example, a sediment pit. Besides, the plurality of objects 50 may include either an obstacle such as a building or a facility provided in the work site S, for example, a mark such as a pyrone (cone) or a bar. The plurality of objects 50 may include water. Specifically, the plurality of objects 50 may include either a puddle on the ground surface 51g or water stored in the container. Besides, it is also allowable to set only a single object 50 in the work site S.

The work site simulation system 1 according to the embodiment has an operator operation mode (operator mode) for allowing a user to operate the work machine 60. The operator operation mode is a motion mode to simulate the motion of a real work machine. In the operator operation mode, the computer 20 makes the work machine 60 perform a motion such as a movement and a posture change in accordance with a manual operation manually applied to the input unit 11 by a user. Specifically, at least a part of the lower main body 61, the upper turning body 63, the boom 65a, the arm 65b, and the tip attachment 65c of the work machine 60 is moved according to the manual operation of the user. The dozer 64 shown in FIG. 17, when included in the work machine 60, may be moved according to the manual operation by a user.

In the operator operation mode, the state of the work site S shown in FIG. 4 may be changed in response to the motion of the work machine 60, for example, a motion for work. In the embodiment, as described later, performed are the deformation of the ground 51 and the movement of the work object 53 according to the motion of the work machine 60.

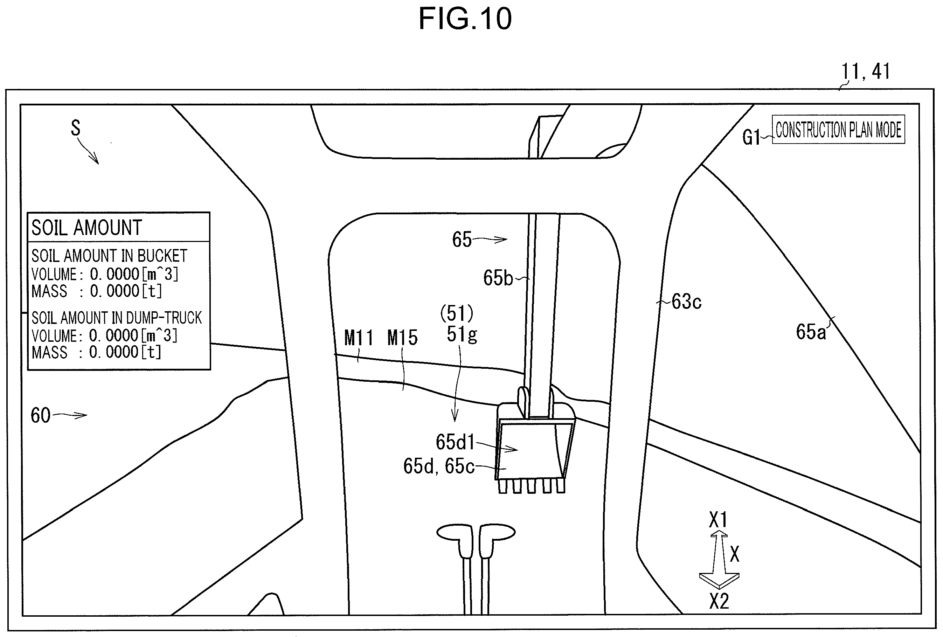

The work site simulation system 1 may further have a mode other than the operator operation mode. For example, the work site simulation system 1 may have a construction plan mode that is a mode for planning work at the work site S. In the case of thus having a plurality of modes, the computer 20 may make the display unit 41 display a mode change part G1 as shown in FIGS. 5 and 10. The mode change part G1 is a GUI displayed by the display unit 41 to enable a user to designate a desired mode from among the plurality of modes. In the embodiment, the mode change part G1 shown in FIG. 5 is a display for enabling the mode to be changed to the operator operation mode (operator mode) shown in FIG. 10 by an operation applied to the mode change part G1, and the mode change part G1 shown in FIG. 10 is a display for enabling the mode to be changed to the construction plan mode shown in FIG. 5 by an operation applied to the mode change part G1.

The display unit 41 may display images from various viewpoints. As illustrated in FIG. 10, in the operator operation mode, the computer 20 makes the display unit 41 display an image viewed from a viewpoint in the operation chamber 63c. In the construction plan mode shown in FIG. 5, the computer 20 makes the display unit 41 display an image from a viewpoint outside the work machine 60, specifically, an image provided by bird's-eye view of the work site S. The viewpoint, however, is also variously settable. For example, the display unit 41 may either display only an image from a single viewpoint or simultaneously display a plurality of images from a plurality of viewpoints.

The computer 20, specifically, the model conversion processing part 21 of the computer 20, performs the model conversion processing, which is the processing of converting the site model M11 into the changeable model M15. Specifically, it is as follows.

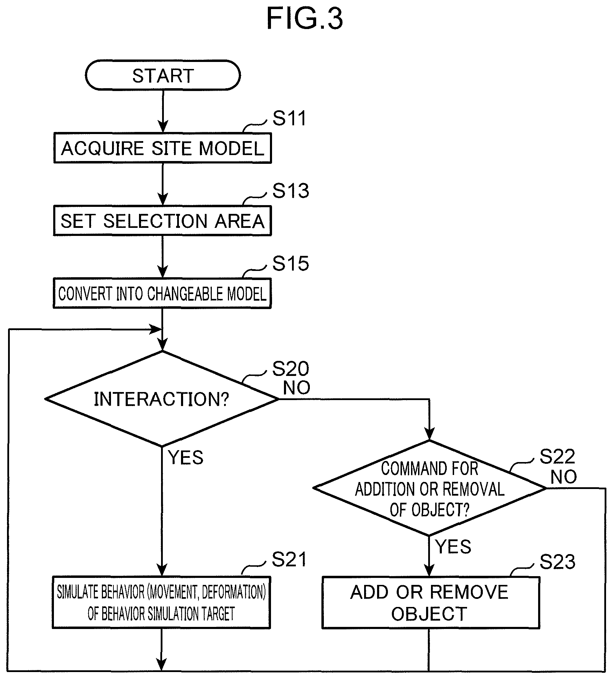

In the simulation of the work site S shown in FIG. 4, the computer 20 performs change processing which is at least one processing of deformation, movement, addition, and removal of at least a part of the plurality of objects 50, for example, the work object 53. While the change processing increases the computation load on the computer 20, the work site simulation system 1 is configured to reduce the computation load on the computer 20 due to the change processing. Specifically, the computer 20 performs processing as shown in the flowchart of FIG. 3.

The computer 20, specifically, the model conversion processing part 21, initially acquires the site model M11 as shown in FIG. 5, that is, the shape information as to the work site S (step S11 shown in FIG. 3). Next, the computer 20 sets the area of a part of the site model M11 as the selection area A13 (step S13). Next, the computer 20 converts the site model M11 into the changeable model M15 shown in FIG. 8 in the selection area A13 (step S15). The computer 20 performs change processing on the changeable model M15, while restricts the change processing to be performed on the site model M11 more than the change processing that is allowed to be performed on the changeable model M15. This allows the computation load on the computer 20 due to the change processing to be reduced, thereby enabling the computer 20 to perform calculation through a calculation method that allows the computer 20 to calculate at high speed. Hereinafter will be described details of the model conversion processing.

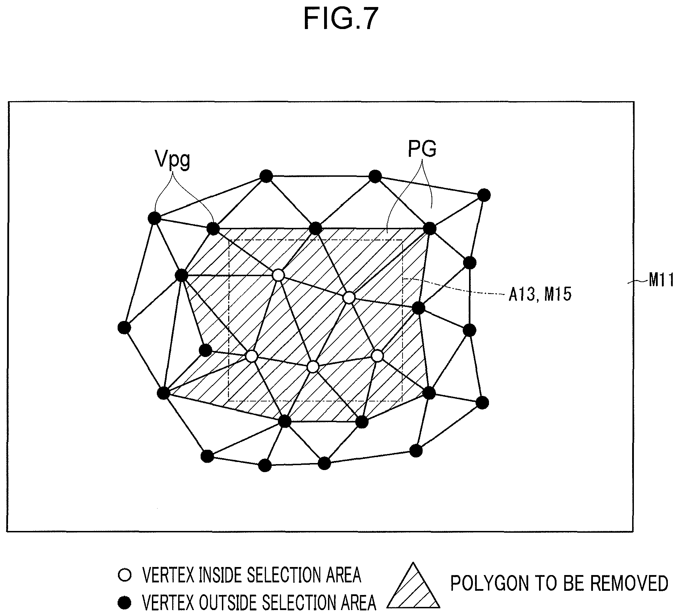

The site model M11 acquired in step S11 is the shape information as to the work site S as described above, including three-dimensional shape information in the embodiment. Specifically, the site model M1 includes a plurality of polygons PG shown in FIG. 7. The polygon PG has a plurality of vertices Vpg, which are not regularly but irregularly arranged. In short, they are set at various positions. The site model M11 may include information on a real work site. For example, the site model M11 may include either information obtained by three-dimensional scanning on a real work site or shape information appropriately converted from a two-dimensional image of a real work site. The site model M11, alternatively, may include information on a virtual work site S, for example, design information.

The site model M11 includes the plurality of objects 50 shown in FIG. 4. Specifically, the site model M11 according to the present embodiment includes at least a part of the ground 51, the work object 53 (e.g., sediment 53s), the work machine 60, and the vehicle 90. The site model M11 may include information on a color, for example, information on the color of the sediment 53s or the like.

As described above, the selection area A13 set by the computer 20, specifically, by the selection area setting part 21a, in step S13 shown in FIG. 3 is the area in which conversion from the site model M11 to the changeable model M15 shown in FIG. 8 is performed, namely, a conversion area. The selection area A 13 may be either an area of a part or a whole of the site model M11. Besides, there may be set a plurality of selection areas A13 in the site model M11. The plurality of selection areas A13 may include either mutually overlapping areas or only mutually separated areas.

The selection area A13 is set to an area that overlaps the site model M11. The selection area A13 may be set to an area that three-dimensionally overlaps the three-dimensional site model M11. The selection area A13 may be set to an area that overlaps the site model M11 when viewed from above in the virtual space, i.e., in a plan view in the virtual space, that is, an area that two-dimensionally overlaps the site model M11.

The selection area A13 may have various shapes. For example, the selection area A13 may be either of a rectangular parallelepiped shape (a rectangular parallelepiped model for range designation, an area box), a columnar shape, a cylindrical columnar shape, and a polygonal columnar shape. The planar shape which is the shape of the selection area A13 in a plan view in the virtual space is also not limited but allowed to be either of a polygon such as a rectangle, a rhombus or a trapezoid, a circle and an ellipse.

The attribute of the selection area A13, namely, a selection area attribute, may be changeable. The selection area attribute includes at least one of parameters including a position, a shape, and a size of the selection area A13. For example, the position of the selection area A13 may be changed by either the translation of the selection area A13 or the rotation of the selection area A13.

The selection area A13 may be arbitrarily either set in accordance with a manual operation applied to the input unit 11 by a user or changed in accordance with the manual operation. It is also allowable that the initial value of the parameter of the selection area A13 is settable. In the embodiment, the computer 20 is configured to automatically set the selection area A13. Specific examples thereof will be described below.

Example 1: The selection area A13 may be set based on the position of the work machine 60. This enables the selection area A13 to be set at an appropriate position corresponding to the position of the work machine 60, thereby enabling an appropriate area corresponding to the position of the work machine 60 to be converted from the site model M11 to the changeable model M15. In Example 1, the work machine 60 is set (disposed) at the work site S before the selection area A13 is set (determined). For example, the work machine 60 is set (arranged) at the work site S after the site model M11 is set and before the selection area A13 is set (determined). The selection area A13 may be set so as to include a part or all of the work machine 60. The computer 20 automatically sets the selection area A13 based on the position of the work machine 60. This reduces the time and effort for a user to set the selection area A13.

Unlike Example 1, in the case of the setting of the selection area A13 not based on the position of the work machine 60, the timing of the setting of the work machine 60 at the work site S may be either before or after the setting of the selection area A13. Besides, in the case of setting the selection area A13 based on the position of the work machine 60, it is also allowable that the temporary setting (temporary determination) of the selection area A13 is performed in advance of the setting of the work machine 60 and the final determination of the temporarily determined selection area A13 is performed based on the position of the work machine 60 after the setting of the work machine 60. For example, it is also allowable that the temporarily determined selection area A13 is changed into a final selection area A13 different from the former selection area A13.

Specifically, the selection area A13 may be set based on the range within which the work machine 60 is operable. Specifically, the computer 20 may be configured to automatically set the selection area A13 based on the range within which the work machine 60 is operable.

For example, the selection area A13 may be set based on a workable range within which the work machine 60 can perform work without traveling. Specifically, the selection area A 13 may be set based on an attachment work range within which the tip attachment 65c reaches. The attachment work range is, more specifically, a range within which the tip attachment 65c is locatable by the turning of the upper turning body 63 and the posture change of the attachment 65 without traveling of the lower main body 61. As an example of the setting of the selection area A13 based on the workable range, the selection area A13 may be set based on the maximum turning radius. The maximum turning radius is the distance from the turning center axis to the tip part of the tip attachment 65c when the tip attachment 65c is located at the position farthest from the turning center axis of the upper turning body 63. As an example of the setting of the selection area A13 based on the workable range, the selection area A13 may be set based on the range within which the tip attachment 65c is movable in the machine vertical direction Z.

In a case where a travelable range, which is the range within which the work machine 60 is capable of traveling, is fixed, the selection area A13 may be set based on the travelable range.

The selection area A13 may be set based on both the travelable range and the workable range. Besides, the selection area A13 may be set so as to move in accordance with the position of the work machine 60 which is traveling. In other words, the selection area A13 may be updated along with the traveling of the work machine 60.

Example 2: The selection area A13 may be set based on the position of the vehicle 90 shown in FIG. 4. This allows the selection area A13 to be set at an appropriate position corresponding to the position of the vehicle 90, thereby enabling the site model M11 to be converted into the changeable model M15 within an appropriate range. In Example 2, the vehicle 90 is set (disposed) at the work site S in advance of the setting of the selection area A13. For example, the selection area A13 may be set so as to contain the vehicle 90. The computer 20 may be configured to automatically set the selection area A13 based on the position of the vehicle 90. This reduces the time and effort for the user to set the selection area A13.

In Example 2, the selection area A13 may be set so as to contain at least a part of the loading platform 91 of the vehicle 90, for example, the interior of the loading platform 91.

Example 3: In the case of the presence of both the work machine 60 and the vehicle 90 in the work site S, the selection area A13 may be set based on respective positions of the work machine 60 and the vehicle 90. For example, the selection area A13 may be set so as to contain both the work machine 60 and the vehicle 90.

Example 4: The computer 20 may be configured to set the selection area A13 based on a numerical value that is input to the computer 20. This allows parameters such as the position and size of the selection area A13 to be precisely set by use of specific numerical values. The setting according to Example 4 is particularly effective when a specific numerical value indicating the position at which the selection area A13 is to be set, e.g., a design position, or the size of the selection area A13, e.g., a design dimension, is predetermined. The case is, for example, a case where the container accommodating the work object 53 shown in FIG. 4 is a not-graphically-shown hole (for example, a sediment pit) dug on the ground surface 51g, and the specific numerical value indicating the position or size of the hole is predetermined. The setting of the selection area A13 based on the numerical value makes it possible to precisely fix an area to be converted into the changeable model M15 (see FIG. 8).

For example, the selection area A13 may be set based on a position designation numerical value designating the position of the selection area A13. The position designation numerical value may include the coordinates of the selection area A13 in an appropriate coordinate system. The coordinates may be either the coordinates of the position of the center of gravity of the selection area A13 or the coordinates of a specific position on the outer edge of the selection area A13 as shown in FIG. 6A (the position of a corner in FIG. 6A). The position designation numerical value may include the rotation angle of the selection area A13 with respect to a predetermined reference direction, for example, the direction of the work machine 60.

The numerical value for setting the selection area A13 may be a size specification numerical value that specifies the size (dimension) of the selection area A13. For example, in the case of the selection area A13 having a rectangular parallelepiped shape, the size specification numerical value may be a numerical value of each of the height, width, and depth of the rectangular parallelepiped. In the case of the selection area A13 having a cylindrical shape, the size specification numerical value may be respective numerical values of the radius and the height of the cylinder.

The numerical value for setting the selection area A13 may be manually input to the computer 20 by an operation applied to the input unit 11 by a user. This allows the user to arbitrarily set the numerical value of the parameter of the selection area A13. For example, the computer 20 may make the display unit 41 display a parameter input part G3 shown in FIG. 5. The parameter input part G3 is a GUI displayed to enable a user to manually input the numerical value of the parameter of the selection area A13. The numerical input to the parameter input part G3 is performed through the input unit 11.

The numerical value for setting the selection area A13 may be a numerical value prestored in the computer 20, for example, a design position or a design dimension.

Example 5: The selection area A13 may be set based on an operation applied to the area change part G5 illustrated in FIG. 5.

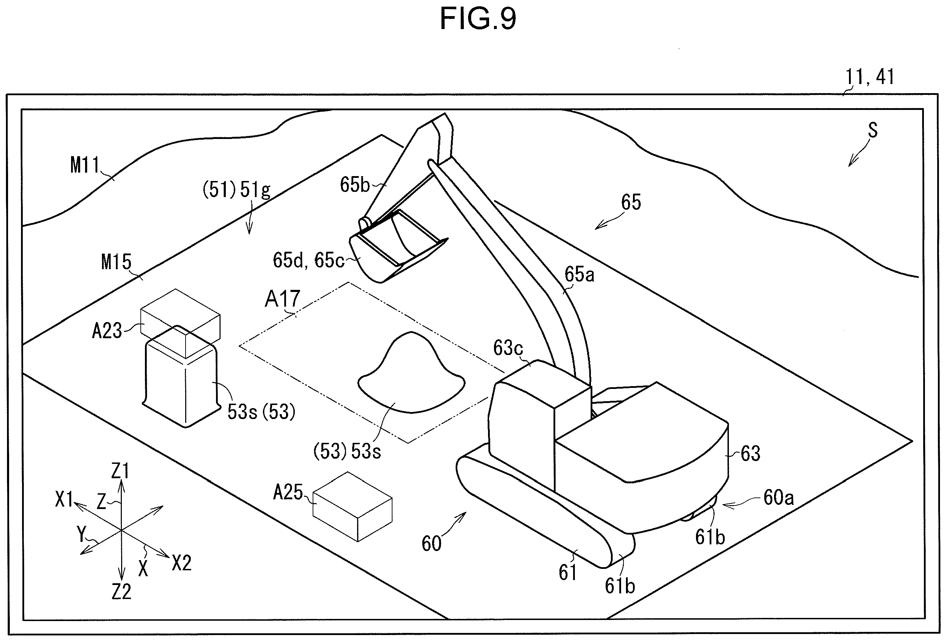

The area change part G5 is displayed to enable a user to change a selection area Attribute which is the attribute of the selection area A 13, that is, at least one of the position, the shape, and the size of the selection area A13. The area change part G5 is a GUI to be displayed on the display unit 41. The computer 20 changes the selection area attribute in accordance with the operation applied to the area change part G5 by a user. The area change part G5 illustrated in FIG. 5 includes an image representing a plurality of coordinate axes (three axes of the X-axis, the Y-axis, and the Z-axis in FIG. 5). The plurality of coordinate axes may be either ones based on the work site S or ones based on the work machine 60, for example, ones corresponding to the upper-turning-body front-rear direction X, the upper-turning-body lateral direction Y, and the machine vertical direction Z, respectively. In the case of the selection area A 13 to be rotated, the area change part G5 may include either an image representing the center axis of the rotation or an image representing the direction of the rotation. The center axis of the rotation may be either one of the plurality of coordinate axes or an axis different from the coordinate axis. For example, in accordance with an operation (for example, a drag operation) applied to an image of any coordinate axis of the area change part G5 shown in FIG. 5, the parameter of the selection area A13 is changed. The area change part G5 is preferably displayed, as shown in FIG. 5, at an appropriate position in the selection area A13, for example, at the center position. The operation applied to the area change part G5 may be one for changing an area different from the selection area A13, for example, an object addition area A23 or an object removal area A25 shown in FIG. 9.

In the example shown in FIG. 5, by the display unit 41 is further displayed a change target selection part G7 in addition to the area change part G5. The change target selection part G7 is displayed to enable a user to select a parameter (for example, a position, a shape, and a size) to be changed through the area change part G5. The change target selection part G7 is a GUI displayed by the display unit 41. The computer 20 determines the target of the change through the area change part G5, in accordance with the operation applied to the change target selection part G7 by a user.

The selection area A13 may be set based on various combination of the above examples. The selection area A13 may be set by a method different from the above example.

The manual operation performed to set the selection area A13 may be either of a numerical value input, a drag operation, a click operation, a tap operation, and a key operation (cursor key operation or the like) other than the numerical value input, or may be a combination of a plurality of operations out of the above operations.

The computer 20 may automatically set the selection area A13 based on the object 50 other than the work machine 60 and the vehicle 90, for example, either of the ground 51, the work object 53, and an obstacle, among the plurality of objects 50. The selection area A13 that is automatically set by the computer 20 may be either straightly fixed as the final selection area A13 as it is or changed (adjusted) by manual operation or the like.

The computer 20 may associate the selection area A13 shown in FIG. 5 with the object 50. For example, the computer 20 may move the selection area A13 accompanying the movement of the object 50 that is associated with the selection area A13 out of the plurality of objects 50. For example, the position of the selection area A13 may be indicated by coordinates based on the position of the object 50 associated with the selection area A13. For example, the computer 20 may associate the selection area A13 with either the selected object 50 when automatically setting the selection area A13 based on the position of the object 50 that is selected from among the plurality of objects 50 or the object 50 not involved in the setting.

As described above, the computer 20, specifically, the changeable model generation part 21c, converts the site model M11 into the changeable model M15 shown in FIG. 8 in the selection area A13 (step S15 shown in FIG. 3), that is, generates the changeable model M15. Specifically, the computer 20 converts the site model M11 into the object 50 in the changeable model M15 to thereby generate the changeable model M15.

In the case of setting the selection area A13 after the generation of the changeable model M15, for example, in the case of setting a new selection area A13 or changing the existing selection area A13, the computer 20 may convert the site model M11 to the changeable model M15 in the newly set selection area A13 while maintaining the changeable model M15 having already generated (that is, may add a new changeable model M15) or delete the already generated changeable model M15 and convert the site model M11 into the changeable model M15 in the newly set selection area A13 (that is, may update the changeable model M15). It may be selectable whether to add or update the changeable model M15, for example, through a user's manual operation or the like. In summary, the computer 20 may be configured to determine whether adding or updating the changeable model M15 based on the manual operation.

In the case of moving the selection area A13 in accordance with the traveling of the work machine 60, as in Example 4 described above, after the generation of the changeable model M15, the computer 20 may convert (for example, update) the site model M11 into the changeable model M15 in the thus moved selection area A13.

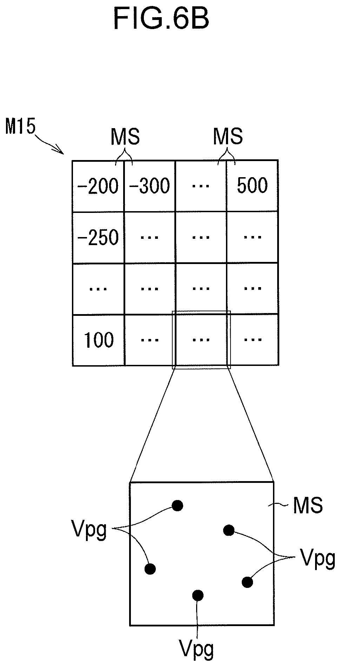

The changeable model M15 is shape information on which change processing is allowed to be performed by the computer 20. The changeable model M15 includes three-dimensional shape information. It is preferable that the shape of the changeable model M15 is simpler than the shape of the site model M11. The changeable model M15 illustrated in FIG. 6A is information involving the combination of the plurality of meshes MS, which are a plurality of rectangles divided vertically and horizontally, and a plurality of pieces of height information attached with the plurality of meshes MS, respectively, as shown in FIG. 6B.

The changeable model M15 may include either the ground 51 shown in FIG. 4 or the work object 53. For example, the changeable model M15 may include either sediment 53s (sediment model) or a work object 53 other than the sediment 53s. The changeable model M15 may include the object-in-container 55. The work machine 60 and the vehicle 90 are not included in the changeable model M15 converted from the site model M11.

The changeable model M15 can be generated, that is, converted from the site model M11, by various methods. Specific examples of the method will be described below.

The computer 20, specifically, the site model cutout part 21b, cuts out, that is, removes, a part in the selection area A13 from the site model M11 shown in FIG. 6A. Specifically, as shown in FIG. 7, the computer 20 acquires information on the vertices Vpg of all the polygons PG that is present in the selection area A13 out of the vertices Vpg of the plurality of polygons PG included in the site model M11, and removes all the polygons PG that includes the thus acquired vertex Vpg, that is, the polygons PG with hatching in FIG. 7. Thus, the polygons PG in the area larger than the selection area A13 are removed. Since the vertices Vpg of the polygons PG included in the site model M11 shown in FIG. 7 are located at respective positions arranged not regularly but irregularly, the outer periphery of the area that is cutout from the site model M11 may have an irregular shape, for example, a polygonal line shape (knurled shape) when viewed from above. Alternatively, it is also allowable to additionally generate the changeable model M15 shown in FIG. 6A while not cutting out but leaving the part corresponding to the selection area A13 in the site model M11.

The computer 20, specifically, the changeable model generation part 21c, generates the changeable model M15 in the selection area A13. Each of the plurality of rectangular meshes MS included in the changeable model M15 is, for example, rectangular. The dimension of one side of the mesh MS, that is, the mesh size, is a predetermined dimension (for example, 100mm) prestored in the computer 20. All meshes MS have the same dimensions. This means that the changeable model M15 is divided at equal intervals. In FIGS. 6A and 6B, only a part of the plurality of meshes MS are shown.

The computer 20 sets height information as to the mesh MS to each of the meshes MS. In each of the meshes MS shown in FIG. 6B is indicated an example of a numerical value corresponding to the height information. For example, with use of the height of a predetermined object 50 among the plurality of objects 50, for example, the height of the bottom surface of the work machine 60, as a reference (e.g., 0), the computer 20 sets the height information of each mesh MS. The computer 20 sets (calculates) the initial value of the height information of each mesh MS, that is, the value before the change processing performed on the changeable model M15. For example, the computer 20 calculates, based on the height information on the site model M11 in an area of one mesh MS, the initial value of height information on the one mesh MS. Specifically, the computer 20 sets the average value of the heights of the vertices Vpg of the polygons PG of the site model M11 in the area of the one mesh MS as the initial value of the height information as to the one mesh MS. More specifically, the computer 20 calculates the initial value of the height information as to the one mesh MS based on the following formula. [Formula 1] $h = \frac{1}{N} {\sum }_{n = 1}^{N} Py , n$
h: Initial value of height information of one mesh MS
Py, n: Height information of vertex Vpg in area of one mesh MS
N: Number of vertices Vpg in area of one mesh MS

As shown in FIG. 5, in the case of existence of a data absence part Mdm, which is a part with no data, in the site model M11, the computer 20 may generate the changeable model M15 shown in FIG. 8 at the position of the data absence part Mdm so as to complement the data absence part Mdm. In short, the computer 20 may be configured to fill the data absence part Mdm.

In the site model M11, the data absence part Mdm is generated, for example, as follows. When acquired by 3D scanning on a real work site, the site model M11 can be generated with a part of the real work site failed to be scanned, which causes a possibility that the part failed to be scanned becomes the data absence part Mdm. Besides, when the information serving as the source of the site model M11 includes information about both the terrain and information other than the terrain (for example, information about the work machine 60) and the site model M11 is acquired based on only the information about the terrain whereas the information other than the terrain is excluded, there is a possibility that the excluded information which is the information other than the terrain becomes the data absence part Mdm.

A specific method of complementing the data absence part Mdm by the computer 20 is variously settable. For example, the computer 20 may generate (complement) the changeable model M15 shown in FIG. 8 at the position of the data absence part Mdm based on a part of the site model M11 where data is present. Specifically, the computer 20 may set initial height information of each mesh MS of the changeable model M15 shown in FIGS. 6A and 6B based on the height information of a part around the data absence part Mdm. For example, the computer 20 may be configured to set the average value of the height around the data absence part Mdm shown in FIG. 5 as the initial height information of the changeable model M15 (the mesh MS shown in FIG. 6B) to be complemented by the data absence part Mdm.

The computer 20 can perform the change processing on the changeable model M15 shown in FIG. 8. The change processing is at least one of deformation, movement, addition and removal of the model. The computer 20 does not restrict the change processing on the changeable model M15. Alternatively, the computer 20 renders the restriction of the change processing on the changeable model M15 looser than the restriction of the change processing on the site model M11.

In other words, the computer 20 restricts the change processing that is allowed to be performed on the site model M11 more than the change processing that is allowed to be performed on the changeable model M15. The scope of the restriction of the change processing on the site model M11 encompasses prohibiting all the change processing on the site model M11. Specifically, the computer 20 may be configured either to perform no change processing on all the site model M11 but to perform the change processing on the changeable model M15 or to perform the change processing on the changeable model M15 and perform only the change processing more restricted than the change processing is allowed to be performed on the changeable model M15 with respect to the site model M11. For example, the computer 20 may be configured either to perform no change processing on the entire site model M11 when the change processing is performable on the whole or a part (e.g., the physical calculation area A17 shown in FIG. 9) of the changeable model M15 or to perform only the change processing from which the specific change processing is excluded on the site model M11 when the specific change processing (e.g., deformation and movement) is performable on the changeable model M15.

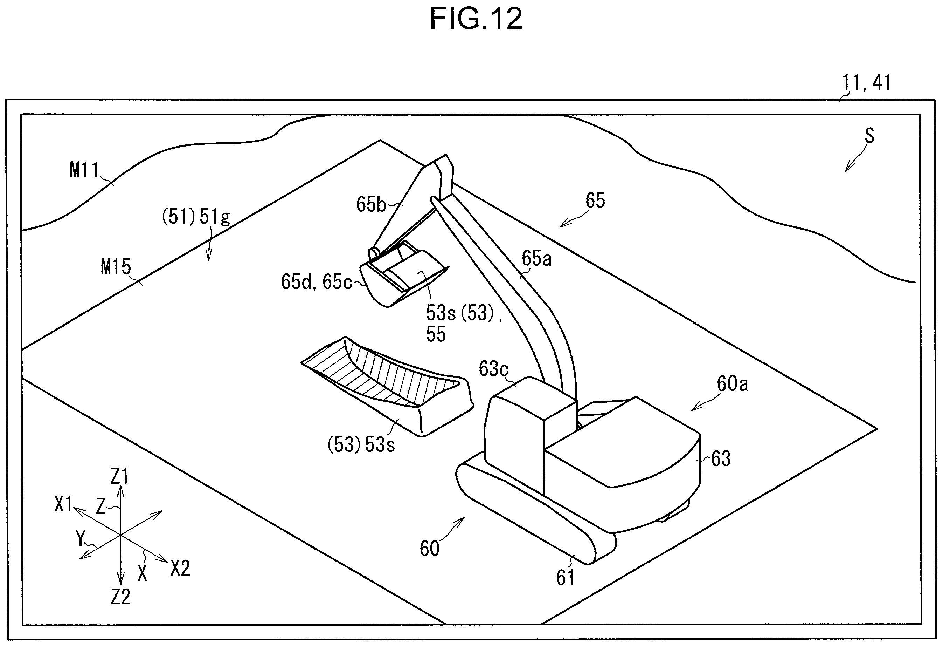

Specifically, the computer 20 performs the change processing when the work machine 60 comes into contact with an object in the changeable model M15, thereby simulating the work to be performed by the work machine 60. More specifically, when the work machine 60 comes into contact with an object in the changeable model M15, for example, when the work machine 60 performs work on the object, the computer 20 performs at least one of the movement and the deformation of the object. For example, when the bucket 65d performs a motion of excavating the sediment 53s in the changeable model M15 as shown in FIG. 12, the computer 20 makes the sediment 53s moved or deformed as if the sediment 53s is excavated.

On the other hand, even when the work machine 60 shown in FIG. 8 comes into contact with an object in the site model M11, the computer 20 does not make the object either moved or deformed. Specifically, the computer 20 performs data processing so as to cause the bucket 65d to pass through an object in the site model M11. Thus, the change processing is restricted so as to prevent the change processing of movement and deformation to be performed when the bucket 65d comes into contact with the object of the changeable model M15 from being performed on the site model M11. This allows the computation load on the computer 20 to be reduced.

The computer 20 makes the display unit 41 display the changeable model M15. The color of the thus displayed changeable model M15 may be set based on the color information in the site model M11. Specifically, the computer 20 acquires information about the color at a corresponding position in the site model M11, the corresponding position corresponding to the position of the changeable model M15 shown in FIG. 6A (for example, the position of each mesh MS), and sets the color of the changeable model M15 at the position to the same color as or close to the thus acquired color of the site model M11. Thus, the computer 20 reflects the color of the site model M11 in the changeable model M15.

The changeable model M15 shown in FIG. 6A is composed of the plurality of meshes MS each having height information as shown in FIG. 6B. The computer 20 may make the display unit 41 display a curved surface obtained by smoothly joining the surfaces of the plurality of meshes MS illustrated in FIG. 6B as the changeable model M15 as shown in FIG. 8. For example, the computer 20 may be configured to determine a curve (for example, a spline curve) that interjoins the plurality of meshes MS shown in FIGS. 6A and 6B and to make the display unit 41 display a surface passing through the curve as the changeable model M15.

As described above, the changeable model M15 is to simulate the work to be performed by the work machine 60, being different from the site model M11 which is the shape information of the work site S. Hence, it is preferable that the computer 20 is configured to make the display unit 41 display an image that enables a user to grasp an actual position corresponding to the changeable model M15. Besides, it is preferable that the computer 20 makes the display unit 41 display an image that enables a user to distinguish the site model M11 from the changeable model M15. Specifically, the computer 20 may be either configured to make the site model M11 and the changeable model M15 displayed in mutually different colors or configured to make the display unit 41 display only the outer periphery (frame) of the changeable model M15. For example, the computer 20 may be configured to make the display unit 41 display (draw) the boundary line between the inside and the outside of the changeable model M15. For example, regarding the gap between the polygon PG (of the site model M11) removed as described above in FIG. 7 and the outer periphery of the selection area A13 (that is, the outer periphery of the changeable model M15), no data being present in the gap, the computer 20 may be configured to render the display of the gap, which is the boundary part between the site model M11 and the changeable model M15, different from either the display of the site model M11 or the display of the changeable model M15. Thus, there may be displayed a boundary part between the changeable model M15 and the site model M11 shown in FIG. 8 on the display unit 41.

As described above, the simulation of work to be performed by the work machine 60 is possible in the changeable model M15 but impossible in the site model M11; hence, it is preferable that the computer 20 makes the output unit 40 output a notification about the deviation of a notification target part, which is set in advance in the work machine 60, from the area of the changeable model M15, when the deviation occurs, to thereby make a user aware of the deviation. This enables the user to perform an operation so as to restrain the notification target part of the work machine 60 from deviating from the changeable model M15.

For example, the computer 20 makes the output unit 40 output a notification when the notification target part of the work machine 60 deviates from the area of the changeable model M15 in a plan view. The notification to be output from the output unit 40 may be either a notification by display or a notification by sound. The notification target part may be either the entire work machine 60 or a part of the work machine 60. The target part may include, for example, any of the lower main body 61, the upper turning body 63, and the work device.

As the change processing to be performed on the changeable model M15, for example, the computer 20 can perform calculation for moving the object 50 included in the changeable model M15 (performing at least one of deformation and movement of the object 50). Meanwhile, performing the calculation for moving the object 50 in accordance with the physical phenomenon over the area of all the changeable model M15 may involve significant increase in the computation load on the computer 20.

To suppress such an increase in the computation load, the computer 20 preferably sets the physical calculation area A17 as illustrated in FIG. 9. The physical calculation area A17 is an area in which the computer 20 is allowed to perform physical calculation, which is a calculation for making the object 50 in the changeable model M15 perform a motion corresponding to a physical phenomenon. In other words, the computer 20 is prohibited from performing calculation for making the object 50 make a motion corresponding to a physical phenomenon, specifically, bringing the object 50 into at least one of movement and deformation corresponding a physical phenomenon, in an area other than the physical calculation area A17. Thus limiting the area in which the physical calculation is to be performed also falls under the restriction of the change processing.

There will be described a case where the object 50 to be simulated in the changeable model M15 is the sediment 53s. When the sediment 53s is put into an area other than the physical calculation area A17 at the work site S, the computer 20 brings the input sediment 53s into a shape not corresponding to a physical phenomenon, for example, a simple shape such as a rectangular parallelepiped shape. In contrast, when the sediment 53s is put into the physical calculation area A17, the computer 20 performs calculation for making the input sediment 53s perform a motion corresponding to a physical phenomenon. For example, the computer 20 makes the sediment 53s perform a deformation caused by the downward movement of the upper part of the sediment 53s having been put due to its own weight, for example, a deformation into a gentle substantially conical shape.

To reduce the computation load, the physical calculation area A17 is set in an area of not the entire changeable model M15 but only a part of the changeable model M15. The physical calculation area A17 is preferably set to an area with high necessity of the physical calculation. For example, it is assumed that the necessity of the physical calculation in the vicinity of the work machine 60 is higher than that in an area far from the work machine 60; hence, it is preferable that the computer 20 sets the physical calculation area A17 based on the position of the work machine 60 at the work site S. Specific examples thereof will be described below.

Example 1: The physical calculation area A17 may be set based on the position of a reference part set in advance in the work machine 60. The reference part may be either the entire work machine 60 or a part of the work machine 60, for example, the bucket 65d. The physical calculation area A17 may be set in an area overlapping the reference part of the work machine 60 in a plan view and an area around the reference part.

In a case where the reference part is set to an appropriate part of the attachment 65, for example, the bucket 65d, the physical calculation area A17 may be set to an area within a range from the bucket 65d to the position separated from the bucket 65d in the upper-turning-body lateral direction Y by a predetermined dimension (e.g., 5m on each of the left and right sides) and in a range from the bucket 65d to the position separated from the bucket 65d in the upper-turning-body front-rear direction X by a predetermined dimension (e.g., 10m).

In the case of setting the position of the physical calculation area A17 by use of a numerical value, the numerical value may be set to a value obtained by multiplying the size of the bucket 65d by a constant coefficient. The numerical value may be, for example, either a planer distance from the bucket 65d to the outer periphery of the physical calculation area A17 or a dimension of the physical calculation area A17 (for example, the dimension in the upper-turning-body lateral direction Y and the dimension in the upper-turning-body front-rear direction X). The coefficient may be either a value stored in advance in the computer 20 or a value to be input to the computer 20 by a manual operation by a user.

The physical calculation area A17 may be set based on a movable range of the attachment 65 in the machine vertical direction Z. For example, the lower limit position of the physical calculation area A17, which is the lowermost position in the machine vertical direction Z, may be set to the position separated downward by a preset distance from the position of the tip of the tip attachment 65c being located at the lowest position in the machine vertical direction Z. Similarly, the upper limit position of the physical calculation area A17, which is the uppermost position in the machine vertical direction Z, may be the position separated upward by a preset distance from the position of the tip of the tip attachment 65c being located at the lowest position in the machine vertical direction Z.

The reference part may be at least one of the pair of traveling units 61b. For example, the physical calculation area A17 may be set to either a position immediately below one of the pair of traveling units 61b or a position around the one of the pair of traveling units 61b, for example, a position between the pair of traveling units 61b.

In Example 2 of the physical calculation area setting: The physical calculation area A17 may be set based on a predetermined work position, which is a predetermined position at which the work machine 60 performs work. The predetermined work position may be set in either of the interior of the container, e.g., the interior of the loading platform 91, the interior of the bucket 65d, and the interior of the sediment pit. The predetermined work position, alternatively, may be a position where the work object 53 is placed on the ground surface 51g, for example, the position of sediment mound.

The shape of the physical calculation area A17 is variously settable. For example, the shape of the physical calculation area A17 in a plan view may be either a polygon such as a rectangle, a rhombus, or a trapezoid as shown in FIG. 9 or a circle. The physical calculation area A17 may be set either only in a single place or in a plurality of places dispersedly.

The computer 20 may move the physical calculation area A17 in accordance with a change in the situation of the work site S. For example, in the case of setting the physical calculation area A17 based on the position of the work machine 60, the computer 20 may move the physical calculation area A17 along with the movement of the work machine 60. As for the case where the object 50 in the physical calculation area A17 is deviated from the physical calculation area A17 by the movement of the physical calculation area A17, the computer 20 may be configured to maintain (keep) the last state in the area of the physical calculation area A17 while keeping the object 50 from movement corresponding to the physical phenomenon.

The computer 20 simulates the behavior of a behavior simulation target object when an interaction occurs between two or more objects included in the plurality of objects 50 (YES in step S20 in FIG. 3), that is, when two or more interaction objects, which are objects between which interaction occurs, are included in the plurality of objects 50 (step S21). The behavior simulation target, which is included in the interaction objects, is an object whose behavior is set as the target of a simulation by the computer 20. When the plurality of objects 50 include the interaction object, the computer 20 simulates at least one of deformation and movement out of the behavior of the behavior simulation target object included in the interaction objects. The object 50 in the changeable model M15 can be the behavior simulation target object. An object not being the object 50 in the changeable model M15, specifically, the object 50 in the site model M11, may be excluded from the behavior simulation target objects. When the physical calculation area A17 is set in the changeable model M15, the object 50 in the physical calculation area A17 can be the behavior simulation target object, and the object 50 outside the physical calculation area A17 can be excluded from the behavior simulation target objects.

Any of the above-described plurality of objects 50 can be the behavior simulation target object. Specifically, the behavior simulation target object may include any of the ground 51 including the ground surface 51g and the work object 53 including the sediment 53s. The behavior simulation target object may include any of an object 50 disposed at a position separated from the ground surface 51g, the object-in-container 55, the work machine 60, and the vehicle 90, or may include water or the like.

The interaction may include either an interaction associated with mutual contact of the interacting objects or a non-contact interaction without the contact. The non-contact interaction may be caused by either of magnetic force, electrostatic force, and gravity, as will be described later. The gravity is an attractive force acting between the ground 51 (Earth) and an object 50 other than the ground 51 (e.g., the work object 53).

The interaction may include an interaction between the work device and the work object 53 which is an object of work to be performed by the work device. The interaction may include either an interaction between at least one of the pair of traveling units 61b (e.g., crawlers) of the lower main body 61 and the ground surface 51g or an interaction between the work objects 53.

The computer 20 determines (calculates) a behavior to be simulated, based on at least one physical quantity (parameter) of the behavior simulation target object. The computer 20 may determine at least one of movement and deformation of the behavior simulation target object based on a physical quantity of the behavior simulation target object.

In the case of the behavior simulation target object being the work object 53, the physical quantity for determining the behavior of the work object 53 may include an amount by which the work device moves the work object 53. The physical quantity may include the relative position of the work object 53 to the work device. The physical quantity may include a force to be applied to the work object 53 by the work device.

The behavior of the behavior simulation target object to be simulated by the computer 20 is variously settable. The behavior simulation processing (calculation) to be performed by the computer 20 for simulating the behavior is included in the above-described change processing. Examples of the behavior of the object 50 are as follows.

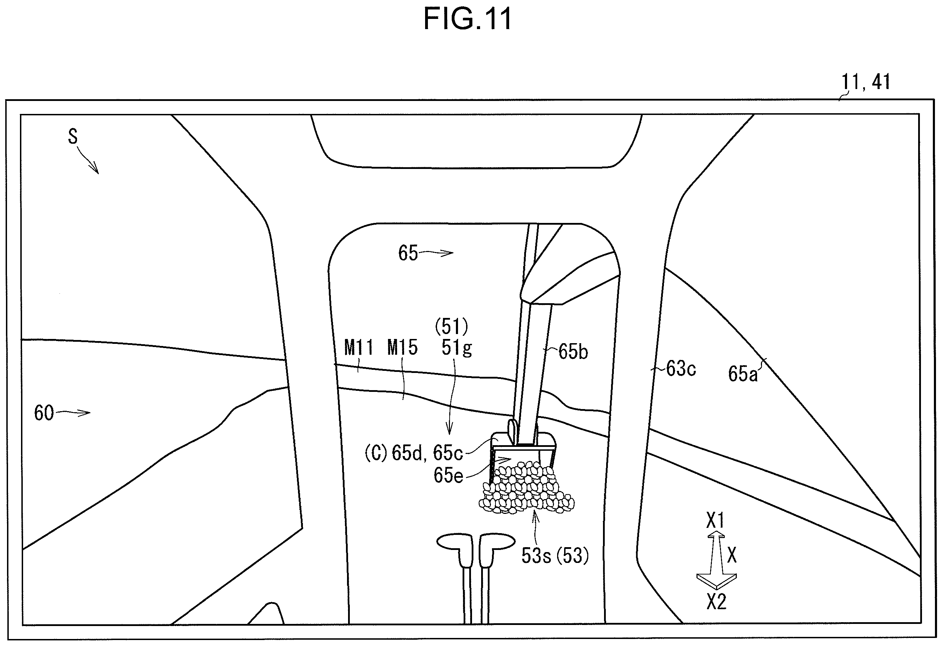

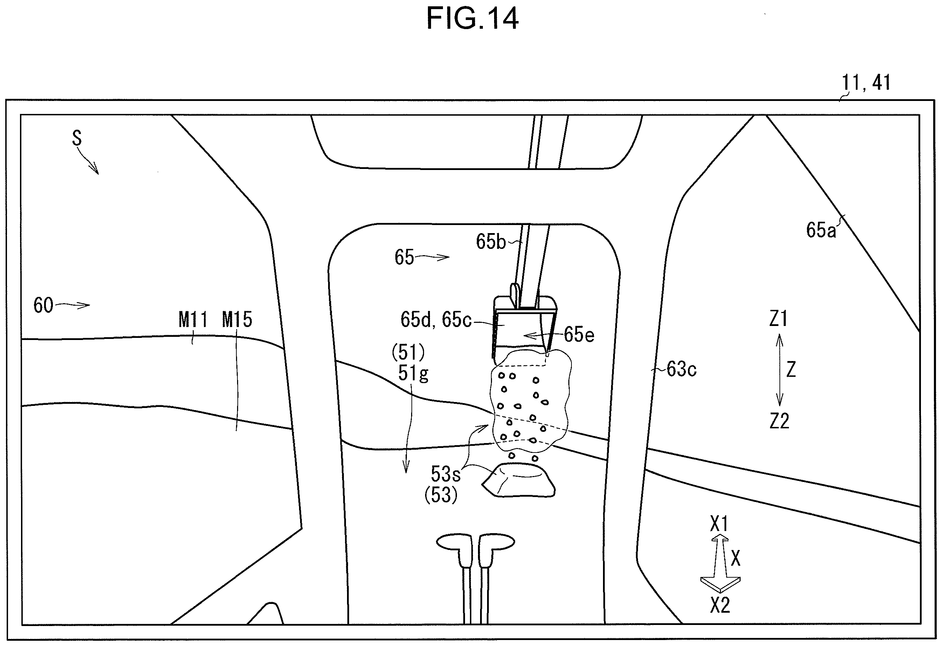

The computer 20 may simulate the movement of the behavior simulation target object caused by the interaction between the interacting objects. For example, the computer 20 may simulate the movement of the work object 53 captured by the tip attachment 65c as shown in FIG. 11, the movement accompanying the movement of the tip attachment 65c. Alternatively, the computer 20 may simulate the movement (for example, falling) of the work object 53 that is released (for example, discharged) from the tip attachment 65c as shown in FIG. 14.

The computer 20 may simulate the deformation of the behavior simulation target object caused by the interaction between the interacting objects. For example, the computer 20 may simulate the deformation of the work object 53 associated with the contact between the tip attachment 65c and the work object 53 as shown in FIG. 11.

Alternatively, the computer 20 may simulate the deformation of the behavior simulation target object involving the movement of the behavior simulation target object.

The behavior simulation target object may be particulate. The computer 20 may simulate the appearance of the particulate behavior simulation target object. The computer 20 does not need to calculate the behavior of each of the plurality of particles constituting the behavior simulation target. The computer 20 makes the display unit 41 perform display of the particulate behavior simulation target object, that is, expression of the particles, so as to enable a user who views the display unit 41 to be aware that the behavior simulation target object is particulate. The particles may be either grains or powder. As shown in FIG. 14, the powder may be either powder dust or a cloud of dust (e.g., soil dust).

The computer 20 may simulate the behavior of water that another object 50 enters, the water being an example of the behavior simulation target object. Specifically, the computer 20 may simulate the appearance of spray of water raised by the other object 50 that enters the water (for example, drops into water).

The computer 20 may simulate the movement and deformation of the sediment 53s excavated by the bucket 65d as shown in FIG. 11.

The computer 20 may simulate the behavior of sediment 53s in the bucket 65d, the sediment 53 excavated by the bucket 65d. For example, the computer 20 may simulate the behavior of the sediment 53s that is being excavated by the bucket 65d to enter the bucket 65d. The computer 20 may simulate the movement of the sediment 53s in the bucket 65d associated with the movement of the bucket 65d during excavation. For example, the computer 20 may simulate the movement of the sediment 53s in the bucket 65d in the upper-turning-body rearward direction X2 associated with the movement of the bucket 65d in the same direction for excavating the sediment 53s in the upper-turning-body rearward direction X2, that is, in the crowd direction. The computer 20 may simulate the deformation of sediment 53s until deposition in the bucket 65d as shown in FIG. 12 during or after excavation.

The computer 20 may simulate the behavior of the ground surface 51g excavated by the bucket 65d as shown in FIG. 12. The computer 20 may simulate the deformation until the sediment 53s of the ground surface 51g is excavated into a recessed shape. The computer 20 may simulate the movement of the excavated ground surface 51g around the excavation position, which is the position of excavation by the bucket 65d.

The computer 20 may simulate a behavior in which the sediment 53s around the excavation position rises higher than the ground surface 51g before excavation. For example, the computer 20 may simulate a behavior in which the sediment 53s located on both outer sides (both left and right sides) of the excavation position in the upper-turning-body lateral direction Y and on the rear side of the excavation position in the upper-turning-body front-rear direction X rises higher than the ground surface 51g before excavation when the bucket 65d excavates the sediment 53s in the upper-turning-body rearward direction X2, that is, in the crowd direction. At this time, the computer 20 may simulate a behavior in which the sediment 53s located on the rear side of the position of the excavation by the bucket 65d, in the upper-turning-body front-rear direction X, out of the sediment around the excavation, position rises highest.

The computer 20 may determine the behavior of sediment 53s present in at least one of the inside and the outside of the bucket 65d at the time of excavation as shown in FIG. 11, according to physical quantity. The physical quantity may include a physical quantity related to the movement of the sediment 53s excavated by the bucket 65d, for example, a distance and a speed. The physical quantity may include an amount of change in the amount of the sediment 53s (soil amount) in the bucket 65d. The physical quantity may include a physical quantity related to the relative position of the bucket 65d to the sediment 53s, for example, an excavation depth and/or an excavation angle. The physical quantity may include a force that the bucket 65d applies to the sediment 53s to excavate the sediment 53s, namely, an excavation force. The physical quantity may include the property of the sediment 53s (soil property). The soil property may include, for example, a moisture content and/or a viscosity.

The computer 20 may simulate the behavior of the sediment 53s until the sediment 53s is brought into particles by the excavation, for example, the deformation of the sediment 53s from a lump to particles. The computer 20 may simulate either the grains of the excavated sediment 53s or the powder of the sediment 53s (e.g., soil dust).

For example, the computer 20 may simulate the behavior in which the sediment 53s inside the bucket 65d during excavation becomes particulate. The computer 20 may either render a whole of the sediment 53s inside the bucket 65d particulate or render only the sediment 53s directly above the tip of the bucket 65d (craw tip) particulate.

The computer 20 may simulate the behavior in which the sediment 53s in the vicinity of the bucket 65d becomes particulate outside the bucket 65d during excavation. Specifically, the computer 20 may render either the sediment 53s on the ground surface 51g of the excavation position particulate or the sediment 53s around the excavation position particulate. The computer 20 may keep particulate the sediment 53s that has been already rendered particulate as it is.

The computer 20 may keep either the sediment 53s in the bucket 65d particulate or the sediment 53s in the vicinity of the bucket 65d outside the bucket 65d particulate during all of the excavation. The computer 20 can judge whether or not the bucket 65d is excavating sediment 53s, for example, as follows. The computer 20 may judge that the bucket 65d is excavating when a condition that the tip part of the bucket 65d (craw tip) is located on the lower side of the ground surface 51g in the machine vertical direction Z and the bucket 65d is moving, that is, the bucket 65d has a speed, is satisfied. The computer 20, conversely, may judge that the bucket 65d is not excavating when the above condition is unsatisfied.

The computer 20 may change the display of the particulate sediment 53s, that is, the expression of the particles, according to the physical quantity (condition). For example, the computer 20 may decide whether to display the sediment 53s in a particulate form in accordance with the physical quantity. The computer 20 may change, according to the physical quantity, at least one of the amount of the sediment 53s to be displayed as particles, the shape of the particle, and the size of the particles.

The computer 20 may change the display of the particulate sediment 53s according to the position of the sediment 53s. Specifically, the computer 20 may display particulate sediment 53s inside and outside the bucket 65d in different modes, respectively. For example, the computer 20 may simulate the behavior of the sediment 53s moving in the bucket 65d while collapsing in the form of particles during excavation. Besides, the computer 20 may simulate a behavior in which sediment 53s (see FIG. 12) outside the bucket 65d and around the excavation position is deposited in a particulate form during excavation.

The computer 20 may change the display of the particulate sediment 53s according to the amount of change in the amount of the sediment 53s (soil amount) in the bucket 65d. Specifically, the computer 20 may increase the particulate sediment 53s with an increase in the amount of change in the soil amount in the bucket 65d and decrease the particulate sediment 53s with a decrease in the amount of change in the soil amount in the bucket 65d.

The computer 20 may change the display of the particulate sediment 53s according to the relative position of the bucket 65d to the sediment 53s. Specifically, the computer 20 may change the display of the particulate sediment 53s according to the excavation depth of the bucket 65d with respect to the sediment 53s, for example, the distance from the ground surface 51g to the tip of the bucket 65d. The computer 20 may change the display of the particulate sediment 53s in accordance with the angle of the bucket tip back surface 65f with respect to the sediment 53s, namely, an excavation angle (bucket angle). More specifically, the computer 20 may increase the particulate sediment 53s with an increase in the excavation depth and with the approach of the angle of the bucket tip back surface 65f to the ground surface 51g to a right angle. The computer may decrease the particulate sediment 53s with a decrease in the excavation depth and/or with a decease in the angle of the bucket tip back surface f with respect to the ground surface 51g.

The computer 20 may change the display of the particulate sediment 53s according to the force applied to the sediment 53s by the bucket 65d, in other words, the reaction force that the bucket 65d receives from the sediment 53s. For example, the computer 20 may increase the particulate sediment 53s with an increase in the force and decrease the particulate sediment 53s with a decrease in the force.

The computer 20 may change the display of the particulate sediment 53s according to the property of the sediment 53s (soil property). As described above, the soil property may include, for example, the moisture content and the viscosity. Specifically, the computer 20 may increase the size of the particle of the particulate sediment 53s with an increase in the moisture content of the sediment 53s and/or with an increase in the viscosity thereof and, conversely, may decrease the size of the particles of the particulate sediment 53s with a decrease in the moisture content of the sediment 53s and/or the decrease in the viscosity thereof.

Similarly to the excavation of the sediment 53s by the tip attachment 65c (specifically, the bucket 65d), the computer 20 may simulate the work of flattening the sediment 53s by the tip attachment 65c, namely, leveling work.

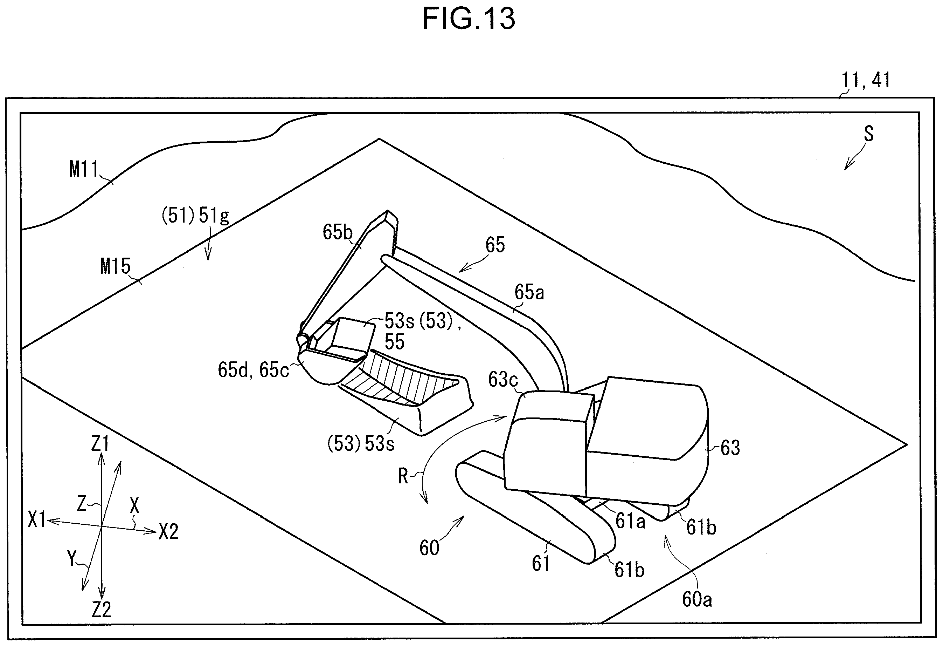

As shown in FIG. 13, the computer 20 may simulate the behavior of the work object 53 captured by the tip attachment 65c when the upper turning body 63 is performing turning motion (moving in the turning direction R) with respect to the lower main body 61. Accompanying the turning of the upper turning body 63 with respect to the lower main body 61, the tip attachment 65c turns with respect to the lower main body 61, that is, moves in the turning direction R.

The computer 20 may simulate the movement of the work object 53 captured by the tip attachment 65c, mainly the movement in the air, accompanying the turning of the tip attachment 65c. For example, the computer 20 may simulate the movement of the sediment 53s in the bucket 65d in the air accompanying the turning of the bucket 65d.

The computer 20 may simulate the movement of the sediment 53s in the bucket 65d caused by the centrifugal force during the turning of the bucket 65d, that is, the relative movement of the sediment 53s to the bucket 65d in the bucket 65d. For example, the computer 20 may simulate spilling (falling) of the sediment 53s from the bucket 65d during the turning of the bucket 65d. The computer 20 may simulate the deformation of the sediment 53s spilled from the bucket 65d into particulate form.

Specifically, the computer 20 may simulate the movement (falling) and the deformation of the sediment 53s discharged from the bucket 65d as shown in FIG. 14.

The computer 20 may simulate the behavior of the sediment 53s in the bucket 65d during earth removal, that is, when the sediment 53s is discharged from the bucket 65d. For example, the computer 20 may simulate a decrease in the sediment 53s in the bucket 65d due to the movement (falling) of the sediment 53s from the bucket 65d. The computer 20 may simulate the disappearance of the sediment 53s in the bucket 65d, that is, the emptiness of the bucket 65d, caused by the soil discharge. The computer 20 may simulate falling, that is, downward movement, of the sediment 53S from the bucket 65d during earth removal. The computer 20 may simulate the stack of the sediment 53s at a falling position to which the sediment 53s falls down from the bucket 65d during earth removal. The position where the sediment 53s is stacked may be, for example, on either a ground surface 51g or the loading platform 91.

Examples of the physical quantity for determining the behavior of the sediment 53s during earth removal include the amount of movement of the sediment 53s discharged from the bucket 65d, the amount of change in the amount of the sediment 53s (soil amount) in the bucket 65d, the position of the sediment 53s in the bucket 65d, and the soil property.

The computer 20 may simulate a behavior in which the sediment 53s that is falling from the bucket 65d becomes particulate. The computer 20 may simulate a behavior in which the sediment 53s that has been fallen from the bucket 65d becomes particulate. The falling of the massive sediment 53s from the bucket 65d is likely to give a sense of discomfort to a user but the discomfort given to a user by the falling of the particulate sediment 53s from the bucket 65d is small. The computer 20, for example, renders the sediment 53s directly below the bucket 65d and around the bucket 65d performing the earth removal particulate.

The computer 20 may change the display of the particulate sediment 53s according to the position of the sediment 53s. Specifically, the computer 20 may simulate the falling of the particulate sediment 53s at a position directly below the bucket 65d while simulates the generation of powdery sediment 53s (soil dust) around the particulate sediment 53s falling directly below the bucket 65d.

The computer 20 may change the display of the particulate sediment 53s according to the amount of change in the amount (soil amount) of the sediment 53s (decrease amount) in the bucket 65d. Specifically, the computer 20 may increase the particulate sediment 53s with an increase in the decrease amount of the sediment 53s in the bucket 65d, in other words, may decrease the particulate sediment 53s with a decrease in the decrease amount of the sediment 53s in the bucket 65d.

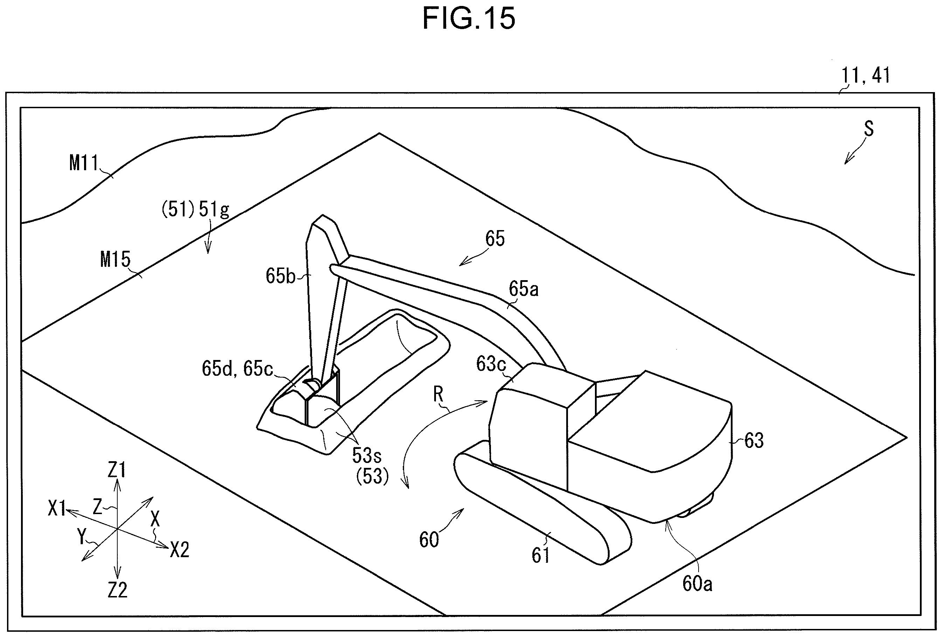

The computer 20 may simulate the movement and deformation of the sediment 53s when the bucket 65d is excavating the sediment 53s in the turning direction R as shown in FIG. 15. Specifically, the computer 20 may simulate the behavior of the sediment 53s when the upper turning body 63 and the attachment 65 turn with respect to the lower main body 61 with at least a part of the bucket 65d buried in the sediment 53s, that is, located below the ground surface 51g.

The computer 20 may simulate the pressing onto the sediment 53s by the side surface (the outer surface in the upper-turning-body lateral direction Y) of the bucket 65d performing excavation in the turning direction R and the movement of the sediment 53s in the turning direction R caused by the pressing. The computer 20 may simulate a behavior in which the sediment 53s located on the front side (the rear side in the upper-turning-body front-rear direction X) of the excavation position, on the back side (the front side in the upper-turning-body front-rear direction X), and the outer side in the turing direction R, respectively, rises higher than the ground surface 51g of the sediment 53s before excavation. For example, the computer 20 may simulate a behavior in which the sediment 53s on the front side in the turning direction R (right side in the rightward turn or left side in the leftward turn) of the sediment 53s around the excavation position of the bucket 65d rises highest.

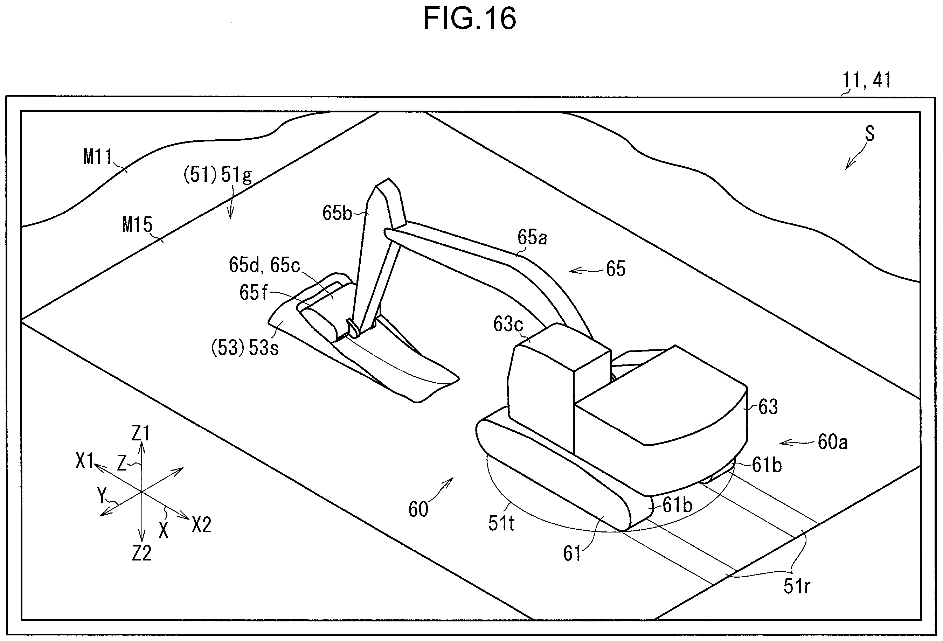

As shown in FIG. 16, the computer 20 may simulate the movement and deformation of the sediment 53s when the bucket 65d is excavating the sediment 53s in the upper-turning-body frontward direction X1. Specifically, the computer 20 may simulate the behavior of the sediment 53s when the arm 65b and the bucket 65d move in the upper-turning-body frontward direction X1, that is, in the arm dump direction, with at least a part of the bucket 65d buried in the sediment 53s, that is, with at least a part of the bucket 65d located below the ground surface 51g.

For example, the computer 20 may simulate the movement of the sediment 53s in the upper-turning-body frontward direction X1 caused by the pressing onto the sediment 53s by the bucket tip back surface 65f moving in the arm pressing direction. The computer 20 may simulate a behavior in which the sediment 53s located on both outer sides (both left and right sides) of the excavation position in the upper-turning-body lateral direction Y and on the front side in the upper-turning-body front-rear direction X, respectively, rises higher than the ground surface 51g of the sediment 53s before excavation accompanying with the arm dump motion. For example, the computer 20 may simulate a behavior in which the sediment 53s located on the front side in the upper-turning-body front-rear direction X out of the sediment 53s around the excavation position is pushed by the bucket 65d to be raised highest.

The computer 20 may simulate the behavior of the work object 53, which behavior is the target of the work performed by the dozer 64 shown in FIG. 17. For example, the computer 20 may simulate the behavior of the sediment 53s that is pressed (soil-pressed) by the dozer 64. For example, the computer 20 may simulate the behavior of the sediment 53s flattened by the dozer 64. Specific example of the behavior of the sediment 53s pressed by the dozer 64 may be equivalent to or substantially equivalent to the excavation of the sediment 53s by the bucket 65d.

The computer 20 may simulate the pressing onto the sediment 53s forming the ground surface 51g and the deformation of the sediment 53s caused by the pressing by the traveling unit 61b (e.g., a crawler) of the lower main body 61 turning with respect to the ground surface 51g (traveling surface) as shown in FIG. 16. For example, the computer 20 may simulate the formation of unevenness caused by the turning of the lower main body 61 on the ground surface 51g that was flat before the turning of the lower main body 61, namely, the formation of a turn mark 51t. The turning of the lower main body 61 with respect to the ground surface 51g may be, for example, either a turn caused by respective motions of the pair of traveling units 61b in opposite directions to each other, namely, a spin turn, or a turn caused by a combination of the stop of one of the pair of traveling units 61b and the motion of the other in the traveling direction, namely, a pivot turn. The computer 20 may simulate the generation of particulate sediment 53s around the traveling unit 61b by the turning of the lower main body 61 with respect to the ground surface 51g.

The computer 20 may simulate the behavior of the sediment 53s constituting the ground surface 51g accompanying the traveling of the lower main body 61 on the ground surface 51g (traveling surface). For example, the computer 20 may simulate the formation of unevenness due to the traveling of the lower main body 61, namely, the formation of the traveling trace 51r, on the ground surface 51g that was flat before traveling of the lower main body 61. The computer 20 may simulate the generation of particulate sediment 53s around the pair of traveling units 61b by the traveling of the lower main body 61 on the ground surface 51g.

The computer 20 may simulate the movement of the object-in-container 55 accompanying the movement of the container. For example, as described above, the computer 20 may simulate the movement of the object-in-container 55 (for example, sediment 53s) in the bucket 65d associated with the movement of the bucket 65d shown in FIG. 13. The computer 20 may simulate the movement of the object-in-container 55 in the loading platform 91 accompanying the movement of the loading platform 91 shown in FIG. 4, similarly to the movement of the sediment 53s in the bucket 65d.

The computer 20 may simulate the movement of the object-in-container 55 from the interior of the container to the exterior thereof, such as spillage or outflow, associated with the movement of the container. The computer 20 may change the behavior of the object-in-container 55 going out of the container according to the physical quantity of the container and the object-in-container 55. The computer 20 may determine whether or not the object-in-container 55 goes out of the interior of the container according to the physical quantity, and may change the amount of the object-in-container 55 going out the container. For example, the computer 20 may change the behavior of the object-in-container 55 going out of the container based on a comparison of the height of the object-in-container 55 (e.g., deposition height) with the height of the wall of the container. An example of the wall of the container is the loading-platform enclosure 91c in the case of the container being the loading platform 91, and a side surface of the bucket 65d (an outer surface in the upper-turning-body lateral direction Y) in the case of the container being the bucket 65d. Specifically, when the height of the object-in-container 55 is equal to or smaller than the height of the wall of the container, the computer 20 may simulate that the object-in-container 55 remains in the container regardless of the movement of the container. When the height of the object-in-container 55 exceeds the height of the wall of the container, conversely, the computer 20 may simulate that the object-in-container 55 goes out of the container accompanying the movement of the container. Besides, the computer 20 may change the manner in which the object-in-container 55 goes out of the container according to the movement speed of the container. For example, the computer 20 may increase the amount of the object-in-container 55 going out of the container with increase in the moving speed of the container.

The tip attachment 65c is not limited to the bucket 65d. The tip attachment 65c may be either a magnet that attracts the work object 53 or one capable of gripping the work object 53. The behavior simulation target object is not limited to the sediment 53s. The behavior simulation target object may be a work object 53 other than the sediment 53s, for example, a magnetic material, a waste, a structure, or the like. Specifically, in the case where the tip attachment 65c is a magnet and the work object 53 is a magnetic material attractable to the magnet by the magnetic force of the magnet, the computer 20 may simulate the behavior of the work object 53 being attracted to the magnet. In the case of the tip attachment 65c capable of gripping the work object 53, the computer 20 may simulate the behavior of the work object 53 gripped by the tip attachment 65c. Besides, the behavior simulation target object may be an object 50 other than the work object 53.

The changeable model M15 may be set (disposed) in each of a plurality of areas. Besides, the behavior simulation target object may be disposed (set) in each of a plurality of areas. For example, at least one of the changeable model M15 and the behavior simulation target object may include a ground surface 51g and an object 50 disposed at a position separated from the ground surface 51g. The position separated from the ground surface 51g is a position on the upper side of the ground surface 51g in the machine vertical direction Z, being a position floating from the ground surface 51g. The "changeable model M15" in the following description is replaceable with also a behavior simulation target object.

In the case where the changeable model M15 includes a ground surface 51g and an object 50 disposed at a position separated from the ground surface 51g, the computer 20 can simulate not only work on the ground surface 51g (e.g., excavation) but also work at a position separated from the ground surface 51g as described later.

As shown in FIG. 12, the changeable model M15 may include a ground surface 51g and a work object 53 captured by the tip attachment 65c. This enables the computer 20 to perform change processing (e.g., movement, deformation) of the work object 53 captured by the tip attachment 65c to thereby simulate work performed on the work object 53 by the tip attachment 65c (capture, movement, release, etc.).

The changeable model M15 may include a ground surface 51g and an object-in-container 55. For example, the changeable model M15 may include a ground surface 51g and sediment 53s in the bucket 65d. This enables the computer 20 to simulate work performed on the sediment 53s by the bucket 65d (excavation, movement, earth removal, and the like). As shown in FIG. 17, the changeable model M15 may include a ground surface 51g and a work object 53 in the loading platform 91. This enables the computer 20 to simulate work performed on the work object 53 in the loading platform 91 (for example, the movement, leveling, or the like of the sediment 53s in the loading platform 91). The changeable model M15 may include a ground surface 51g, a work object 53 in the bucket 65d as shown in FIG. 12, and a work object 53 in the loading platform 91. This enables the computer 20 to simulate work including: capturing the work object 53 from the ground surface 51g by the bucket 65d; moving the work object 53 to the loading platform 91; releasing the work object 53 over the loading platform 91; and loading the work object 53 onto the loading platform 91.

For example, in the case of the changeable model M15 including the ground surface 51g and the interior of the loading platform 91, when the sediment 53s is discharged from the bucket 65d directly above the loading-platform enclosure 91c (tilt plate) of the loading platform 91, the computer 20 simulates, for example, the falling of a part of the sediment 53s discharged from the bucket 65d onto the ground surface 51g outside the loading platform 91, and further simulates the stack of the sediment 53s dropped onto the ground surface 51g. On the other hand, the computer 20 simulates the falling of the remaining of the sediment 53s discharged from the bucket 65d, that is, the sediment 53s that has not fallen onto the ground surface 51g, into the loading platform 91, and further simulates the stack of the sediment 53s dropped onto the loading platform 91 in the loading platform 91.

The object 50 disposed at a position separated from the ground surface 51g is disposed within the range of the changeable model M15 set on the ground surface 51g in a plan view. For example, the sediment 53s in the bucket 65d disposed at a position separated from the ground surface 51g is disposed within the range of the changeable model M15 on the ground surface 51g in a plan view.

When the object 50 disposed at a position separated from the ground surface 51g moves out of the range of the changeable model M15 on the ground surface 51g, the computer 20 may either render the object 50 a model other than the changeable model M15 or make the output unit 40 output (notify) that the change processing to the object 50 is unperformable.

The computer 20 may either add a new object 50 to the work site S in the virtual space or remove a predetermined object 50 from the work site S (step S23 shown in FIG. 3). The addition or removal may be performed in response to an input of a command to the computer 20 (YES in step S22 in FIG. 3).

The computer 20 may be configured to bring the object 50 to be simulated in the changeable model M15 into a predetermined state which is a state predetermined in the computer 20. The predetermined state may involve either the addition of a new object 50 to the work site S or the removal of a selected object 50 from the work site S.

The computer 20 may return the state of the predetermined object 50 to an initial state, that is, may reset the state. The predetermined state may be the initial state. The initial state may be a state when the changeable model M15 is generated, that is, a state when the site model M11 shown in FIG. 8 is converted into the changeable model M15. The predetermined state is not limited to the initial state. The predetermined state may be either one determined based on information input by a user through the input unit 11 or one recorded at a predetermined input timing during simulation of the work site S by the computer 20 (during calculation). The input timing may be either a timing arbitrarily designated by a user through the input unit 11 or a timing automatically set by the computer 20 (for example, timings at a predetermined time or a timing when a predetermined event occurs). The computer 20 may either bring one object 50 into a predetermined state or bring a plurality of objects 50 into respective predetermined states.

The computer 20 may bring the ground surface 51g into a predetermined state. The predetermined state of the ground surface 51g may be, for example, either the initial state or a state where the ground surface 51g is in a specific shape, for example, a planar shape.

The computer 20 may bring the object-in-container 55 into a predetermined state. Examples of the predetermined state of the object-in-container 55 include the initial state, a state where the container is empty, that is, a state where there is no object-in-container 55, and a state where a specific amount of object-in-container 55 are contained in the container. The specific amount may be either an amount stored in advance in the computer 20 or an amount determined by the computer 20 based on information input to the computer 20 through the input unit 11 (for example, an amount manually set by a user).

The computer 20 brings the object 50 into the predetermined state according to an instruction (command) for bringing the object 50 into the predetermined state. For example, the computer 20 may make the display unit 41 display an operation part (for example, a GUI such as a button) that is a part to which a command operation for bringing the object 50 into the predetermined state can be applied. In this case, the computer 20 brings the object 50 into the predetermined state based on the command operation applied to the operation part.

Thus bringing the object into the predetermined state, the computer 20 can repeat the simulation of the same situation.

For example, in the case of the work site simulation system 1 shown in FIG. 1 used as an operation simulation apparatus (for example, a practice apparatus) for simulating an operation for a real work machine, bringing the object 50 into the predetermined state enables a user to practice the same operation easily and repeatedly. For example, the necessity of a troublesome operation is eliminated for a user to operate the work machine 60 to bring the object 50 into a predetermined state (for example, to return the object 50 to the original position).

Specifically, in the case where the predetermined state of the work object 53 is a state of being captured by the tip attachment 65c shown in FIG. 13, the following effect can be obtained. For example, in the case of the tip attachment 65c performing a series of work operations including capturing the work object 53 (e.g., excavation), turning with lifting (movement to a release position), releasing the work object 53 (e.g., earth removal), and return turning (returning to the capture position), bringing the work object 53 into the predetermined state enables a user to practice a part of the series of work operations (for example, only capture or only release) easily and repeatedly. More specifically, in the case where a user performs an operation, with sediment 53s contained in the bucket 65d, to make the bucket 65d turned and lifted up and make earth removal from the bucket 65d performed, the computer 20 can bring the sediment 53s into a state of being contained in the bucket 65d as the predetermined state to thereby enable the user to practice the operation for the lifting with turning and the operation for the earth removal without performing the return turning and the operation for the excavation.

Besides, in the case where the predetermined state of the work object 53 is a state of being contained in the loading platform 91 shown in FIG. 17, the computer 20 can perform an appropriate simulation of the situation of the work object 53 in the loading platform 91 by bringing the work object 53 into the predetermined state. For example, in the case where the work machine 60 loads the work object 53 on the loading platform 91 (for example, earth removal) to store the work object 53 in the loading platform 91, the computer 20 can bring the work object 53 into a predetermined state of being absent in the loading platform 91 (the state where the loading platform 91 is empty) to thereby simulate a situation where the loading platform 91 of the vehicle 90 has become empty as a result of the leaving of the vehicle 90 from the work site S and the following entry of the vehicle 90 into the work site S with the loading platform 91 empty.

The computer 20 may perform processing of adding the object 50 to the work site S as shown in FIG. 9. Specifically, the computer 20 may add (input) either the work object 53 or an object 50 other than the work object 53 to the work site S. For example, the computer 20 may add the object 50 to either the ground sirfa51g or the container shown in FIG. 17 etc..

Adding (inputting) the work object 53 to the work site S, the computer 20 can simulate a situation where the work object 53 is put into the work site S. For example, by adding an object to carry-in the work object 53 (for example, a loading platform 91, a conveyor, or the like shown in FIG. 17), the computer 20 is enabled to simulate a situation where the work object 53 has been put into the work site S. For example, even when the work machine 60 performs the work of capturing (for example, excavating) the work object 53 to reduce the work object 53 at the work position that is the position where the work has been performed, adding the work object 53 to the work position enables the simulation of the work on the work object 53 by the work machine 60 to be continued.

In the case of the work site simulation system 1 shown in FIG. 1 used as an operation simulation apparatus (for example, a practice apparatus) for simulating an operation for a real work machine, adding the work object 53 to the work site S enables a user to perform effective practice. For example, in a situation where the vehicle 90 shown in FIG. 4 has charged sediment 53s onto the ground surface 51g to form soil mound that is the mound of the sediment 53s, the computer 20 enables a user to repeatedly practice an operation for making the work machine 60 perform work on the soil mound (for example, capture and leveling).

The processing of adding the object 50 is performed, for example, as follows. The computer 20 sets the object addition area A23 as shown in FIG. 9 at the work site S. The object addition area A23 is an area to which the object 50 (e.g., the work object 53) is to be added. The computer 20 adds the object 50 by amount set in the computer 20 to the object addition area A23 at the work site S. The object addition area A23 is set in an area of the changeable model M15. The computer 20, thus, adds the object 50 to the object addition area A23 in the area of the changeable model M15.

The position, shape, and size of the object addition area A23 are variously settable similarly to the selection area A13. The initial state of the object addition area A23 may be stored in the computer 20. The position, shape, and size of the object addition area A23 may be either automatically set by the computer 20 based on the situation of the work site S (such as the position of the object 50) or manually set by a user. Specific examples of the setting of the object addition area A23 are the same as the specific example of the setting of the selection area A 13. There may be set an initial value of the input amount of the object 50 in the object addition area A23. The input amount may be, for example, either automatically set by the computer 20 based on the situation of the work site S or manually set by a user.

The computer 20 may perform processing of removing a specific object 50 from the work site S. The computer 20 may remove some of the objects 50 in the changeable model M15 from the changeable model M15. Specifically, the computer 20 may remove either the work object 53 or an object 50 other than the work object 53 from the work site S. The computer 20 may remove either an object 50 or an object-in-container 55 shown in FIG. 17 from the ground surface 51g.

Even when the tip attachment 65c has released the work object 53 (e.g., earth removal) to increase the work object 53 at the release position where the release has been performed as shown in FIG. 14, the computer 20 can continue the simulation of the work on the work object 53 by removing the work object 53 from the release position where the work object 53 has been thus increased.

The processing of removing the object 50 is performed, for example, as follows. The computer 20 sets the object removal area A25 as shown in FIG. 9 at the work site S. The object removal area A25 is an area from which a predetermined object 50 (for example, the work object 53) is to be removed. The object removal area A25 is an area from which the object 50 in the changeable model M15 is to be removed. The computer 20 removes the object 50 (e.g., the work object 53) from the object removal area A25 in the changeable model M15. As for the case where at least a part of the object removal area A25 is included in the site model M11, the computer 20 may be configured not to remove the object 50 in the site model M11 even in the object removal area A25. The position, shape, and size of the object removal area A25 are variously settable. Specific example of the setting of the position, shape, and size of the object removal area A25 are the same as the specific example of the setting in the object addition area A23.

The computer 20 may calculate an amount of at least a part of the plurality of objects 50. The amount of the object 50 calculated by the computer 20, namely, an object amount, may include, as shown in FIG. 10, either the mass of the object 50 or the volume of the object 50. The computer 20 may calculate the object amount at a predetermined time point. The computer 20 may calculate a change amount of the object amount from a predetermined first time point to a second time point after the first time point.

The computer 20 may calculate a work amount by the work machine 60. The work amount represents productivity or workload. As the work amount, for example, the computer 20 may calculate the amount of the work object 53.

The computer 20 may calculate, as the work amount, either the amount of the work object 53 in a determined area or the amount of change in the amount. The area of the determined area includes an area in which the work object 53 is collected, for example, soil mound.

The computer 20 may calculate the amount of the object-in-container 55 as the object amount. For example, the computer 20 may calculate either of the amount of the work object 53 in the bucket 65d shown in FIG. 12 (for example, a soil amount in bucket shown in FIG. 10 or the change amount thereof), the amount of the work object 53 captured (scooped up) by the bucket 65d, and the amount of the work object 53 in the loading platform 91 shown in FIG. 4 (for example, a soil amount in dump-truck shown in FIG. 10). The calculation of the work amount by the computer 20 may be performed based on the amount of the object-in-container 55 (for example, based on the amount of change in the amount).

The computer 20 can variously use the value calculated as described above (the object amount, the work amount calculated from the object amount, and the like), namely, a calculated value. For example, the computer 20 may perform either of making the output unit 40 output the calculated value to notify a user, making the display unit 41 display the calculated value as shown in FIG. 10, and making the audio output unit 43 output the calculated value as shown in FIG. 1. The computer 20 may store the calculated value in the storage part 20a shown in FIG. 1. The computer 20 may evaluate the work amount or the like based on the calculated value.

The computer 20 can set the color of the object 50 displayed on the display unit 41 variously as shown in FIG. 4. The computer 20 may change the color of the object 50 according to the situation (condition) of the work site S.

For example, as for the case of the object 50 including the deformable sediment 53s as shown in FIG. 12, the computer 20 may be configured to render the display of the surface of the deformed sediment 53s different from the display of the surface of the undeformed sediment 53s. This enables a user to easily discriminate between the deformed sediment 53s and the undeformed sediment 53s.

The deformation of the sediment 53s is caused by, for example, the contact of the work machine 60 with the sediment 53s. Specifically, the deformation of the sediment 53s may include one caused by the motion performed by the work machine 60 for work on the sediment 53s (for example, excavation). More specifically, the deformed sediment 53s may include either sediment 53s recessed by the excavation or sediment 53s raised by the excavation around an excavation position at which the excavation is performed. Alternatively, the deformed sediment 53s may include sediment 53s stacked by earth removal as shown in FIG. 14 or the sediment 53s of the ground surface 51g deformed by the motion of the machine body 60a, for example, the traveling of the lower main body 61 or the turning of the upper turning body 63. The sediment 53s of the ground surface 51g thus deformed does not necessarily have to be the work object 53 which is the object of the work by the work machine 60.

The computer 20 judges presence or absence of the deformation of the sediment 53s illustrated in FIG. 12 etc., thereby judging whether or not to change the display of the sediment 53s. For example, in order to judge the presence or absence of the deformation, the computer 20 compares a current height, which is the height of the current sediment 53s, with a past height, which is the height of the sediment 53s in the past. The past height is, for example, the height (height information) of sediment 53s at a predetermined judgment target position at a time point when the site model M11 is converted into the changeable model M15, that is, in the initial state; the current height is the height of the current sediment 53s at the height determination position. The computer 20 judges that the sediment 53s at the judgment target position is deformed when the absolute value of a difference between the past height and the current height exceeds a threshold, whereas judges that the sediment 53s at the judgment target position is not deformed when the difference is equal to or less than the threshold. The threshold value may be either zero or a value greater than zero.

As an example of rendering the display of the surface of the deformed sediment 53s different from the display of the surface of the undeformed sediment 53s as described above, the computer 20 may be configured to render the color of the surface of the deformed sediment 53s different from the color of the surface of the undeformed sediment 53s. For example, the computer 20 may be configured to render the color of the surface of the deformed sediment 53s a deeper (darker) color than the color of the surface of the undeformed sediment 53s. According to this, the color of the sediment 53s deformed by the work by the work machine 60 (for example, excavation) is rendered deeper (darker) than the color of the other sediment 53s, thereby allowing the change in the sediment 53s caused by the work performed by the real work machine to be effectively simulated. That is because the inner sediment out of the real sediment usually includes much moisture to have a deep (dark) color compared with the superficial sediment.

The sediment 53s thus displayed differently depending on the presence or absence of deformation, namely, a display change target sediment, is at least a part of the sediment 53s in the changeable model M15. Specifically, the display change target sediment may be either all of the sediment 53s in the changeable model M15 or a part of sediment 53s in the changeable model M15. The part of the sediment 53s may be either the sediment 53s forming the ground surface 51g or the sediment 53s having been deformed by specific work (for example, excavation).

The computer 20 may change the display of the surface of the deformed sediment 53s according to the amount of change in a surface height, which is the height of the surface thereof. Specifically, the computer 20 may change the display of the surface of the deformed sediment 53s according to the difference of the surface height of the deformed sediment 53s from the surface height of the sediment 53s before the deformation at a predetermined display change target position in a plan view. The change may be either a change of the color density of the sediment surface or a change of the hue of the sediment surface. For the change may be used a heat map, which is a method of visualizing the intensity of matrix-type numeral data in color. As described above, changing the display of the surface of the sediment 53s deformed by the work by the work machine 60 according to the amount of change in the surface height of the sediment 53s enables a user to easily grasp the work amount (for example, the excavation depth and the stacking height).

In order to make the computer 20 of the work site simulation system 1 shown in FIG. 1 execute the work site simulation method corresponding to the above-described processing, the work site simulation program is set.

As has been described, there is provided a work site simulation system including a computer that simulates a motion of a work machine at a work site in a virtual space. The computer is configured to perform acquiring a site model that is shape information about a shape of the work site, setting an area of a part of the site model as a selection area, and converting the site model into a changeable model in the selection area. The changeable model is shape information that allows change processing to be performed by the computer, the change processing being at least one of deformation, movement, addition, and removal. The computer is configured to restrict the change processing on the site model more than the change processing that is allowed to be performed on the changeable model.

The restriction of the change processing on the site model enables the computation load on the computer to be reduced due to the simulation.

More specifically, the computer, setting an area of a part of the site model as the selection area and converting the site model into the changeable model in the selection area, can render the area of the changeable model smaller than the area of the site model before the conversion, unlike a case where the entire site model is converted into the changeable model, thereby reducing the computation load on the computer due to the change processing.

The restriction of the change processing on the site model may be prohibiting any of the change processing allowed to be performed on the changeable model from being performed on the site model. This enables the computation load on the computer to be reduced maximumly.

The changeable model preferably includes a work object that is an object of work to be performed by the work machine. This enables the work site simulation system to simulate work to be performed on the work object by the work machine.

Preferably, the computer is configured to set the selection area based on a range within which the work machine is operable. This makes it possible to set, as the selection area, an appropriate area corresponding to the range within which the operation of the work machine is performable in the site model. Specifically, the selection area, which is the area in which the site model is converted into the changeable model, can be prevented from being excessively large with respect to a range within which the work machine is operable, which can effectively reduce the computation load applied to the computer due to the change processing. On the other hand, the selection area can be also prevented from being excessively small with respect to a range within which the work machine is operable, which enables the computer to appropriately perform change processing on an object around the operating work machine. The work site simulation system, thus, can appropriately simulate a situation around the operating work machine. Besides, automatically setting the selection area, the computer can reduce the time and effort for a user to manually set the selection area.

The computer may be configured to set the selection area based on a numerical value that is input to the computer. This allows the selection area to be precisely set based on the numerical value.

Preferably, the work site simulation system includes a display unit capable of displaying information, and the computer is configured to make the display unit display an area change part. To the area change part can be applied an operation for changing a selection area attribute, which includes at least one of a position, a shape, and a size of the selection area. The computer, changing the selection area attribute in accordance with the operation applied to the area change part, enables a user to easily change the selection area attribute by applying the operation to the area change part.

The computer 20 may be configured to set a part of an area of the changeable model as a physical calculation area. The physical calculation area is an area in which calculation for making an object included in the changeable model perform a movement corresponding to a physical phenomenon is allowed to be performed by the computer.

The setting of the physical calculation area restricts the area in which the physical calculation, which is the calculation for making the object perform a movement corresponding to a physical phenomenon, is performed, thereby enabling the computation load on the computer to be reduced.

The computer is preferably configured to set the physical calculation area based on a position of the work machine at the work site. This enables a preferred simulation corresponding to the position of the work machine to be performed.

It is preferable that the work site simulation system further includes an output unit capable of outputting information. As for the case, if configured to make the output unit output a notification when a notification target part included in the work machine deviates from an area of the changeable model, the computer can enable a user to be aware of the deviation.

Preferably, the computer is configured to bring an object included in the changeable model into a predetermined state that is determined in advance. This enables the convenience of the work site simulation system to be improved.

For example, the computer may be configured to bring a ground surface included in the changeable model into the predetermined state. This enables a simulation about the work by the work machine on the ground surface to be performed.

The changeable model may include an object-in-container which is an object contained in a container. This allows the computer to perform a change processing on the object-in-container, thereby enabling the computer to simulate a situation in the container.

Besides, the computer can be also configured to bring the object-in-container into the predetermined state. This enables the computer to adapt to a change in the interior state of the container or the like.

The computer may be configured to calculate an amount of the object-in-container. This enables the computer to perform processing using information on the amount of the object-in-container. For example, in the case where the container is a bucket and the object-in-container is sediment, the computer can calculate an amount of sediment in the bucket, the segment having been excavated by the bucket. Besides, in the case where the container is a loading platform and the object-in-container is a work object, the computer can calculate an amount of the work object loaded on the loading platform (for example, a work amount).

In the case where the changeable model includes the work object, the computer may be configured to calculate a change amount of an amount of the work object in a calculation target area set in the changeable model. This enables the computer to perform processing using the change amount of the amount of the work object in the calculation target area.

In the case where the changeable model includes the work object, the computer may be configured to perform setting an object addition area in the changeable model and adding the determined amount of work object to the object addition area. This enables the work site simulation system to simulate the addition of work objects to the work site. For example, the work site simulation system can simulate input of the work object to a loading platform, a conveyor, or the like at a work site, and the like.

In the case where the changeable model includes the work object, the computer may be configured to perform setting an object removal area in the changeable model and removing the work object that is predetermined from the object removal area. This allows the work site simulation system to simulate the disappearance of the work object from the work site. For example, the work site simulation system can simulate the returning to a before-work state (for example, flat ground) of the work object that has been stacked by the work performed by the work machine (for example, soil mound).

As for the case where the work site simulation system includes the display unit and the changeable model includes deformable sediment 53s, it is preferable that the computer is configured to make the output unit display a surface of the deformed sediment in a mode different from a mode of a display of a surface of the undeformed sediment. This enables a user to easily grasp the presence or absence of deformation of the displayed sediment.

Preferably, the computer is configured to perform setting two or more interaction objects including a behavior simulation target object in the virtual space and simulating a behavior of the behavior simulation target object associated with an interaction between the interaction objects. The behavior includes at least one of deformation and movement of the behavior simulation simulation object. This enables the behavior of the behavior simulation simulation object at the work site in the virtual space to be closer to the behavior of the object at the real work site. The behavior of the object at the real work site is, therefore, enabled to be reproduced with higher accuracy in the virtual space. Thus can be reduced a discomfort of a user to the behavior of the behavior simulation simulation object in the virtual space.

The behavior simulation target object may include sediment. This allows the computer to simulate the behavior of the sediment.

The behavior simulation target object may include a ground surface. This enables the computer to simulate the behavior of the ground surface. Examples of the behavior include the stack of sediment on the ground, behavior associated with excavation of sediment forming the ground surface, and the like.

The behavior simulation target object may include a ground surface and an object located at a position separated from the ground. This allows the computer to simulate not only the behavior of the ground surface but also the behavior of the object at a position separated from the ground.

The behavior simulation target object may include an object-in-container that is an object contained in a container. This enables the computer to simulate the behavior of the object-in-container, for example, an object in a bucket or an object in a loading platform.

The behavior simulation target object may include the work object. This enables the computer to simulate the work object.

As for this case, it is preferable that the interaction object includes the work object and the work device that is included in the work machine and performs work on the work object as a target. This enables the computer to simulate the behavior of the work object due to the interaction between the work device and the work object, thereby enabling the computer to simulate the work to be performed on the work object by the work device.

The computer can be also configured to simulate a behavior of the behavior simulation target object, the behavior involving a movement of the behavior simulation target object. This allows the behavior of the object at the work site in the virtual space, namely, the simulated behavior, to be closer to the behavior of the object at the real work site.

The computer may be configured to simulate the behavior simulation target object that is particulate. This allows the behavior of the object at the work site in the virtual space, namely, the simulated behavior, to be closer to the behavior of the object at the real work site.

In the case where the behavior simulation target object includes the work object, the computer may be configured to determine a behavior of the particulate work object based on a physical quantity related to the work object. The physical quantity helps the behavior of the particulate work object be closer to the behavior of the actual work object. The physical quantity includes, for example, at least one of an amount by which the work object is moved by the work device, a relative position of the work device to the work object, and a force applied to the work object by the work device.

For example, as for the case where the work object included in the behavior simulation target object includes sediment in a bucket included in the work device of the work machine, the physical quantity preferably includes at least one of a change amount of an amount of the sediment in the bucket, an amount by which the sediment is moved by the bucket, a relative position of the bucket to the sediment, and a pressing force applied to the sediment by the bucket. The physical quantity more effectively helps the behavior of the particulate sediment at the work site in the virtual space be closer to the behavior of the particulate sediment at the real work site.

The above-described embodiment (including the modification of the embodiment (hereinafter, the same)) may be variously modified. For example, the number of constituent elements of the above-described embodiment may be changed, or a part of the constituent elements is also allowable not be provided. For example, the arrangement of the components may be changed. For example, the connection between the components shown in FIGS. 1 and 2 may be changed. For example, the inclusion relationship of the components may be variously changed. For example, what is described as a lower component included in an upper component does not have to be included in the upper component or may be included in another component. For example, one element described as a plurality of elements different from each other may be used as one element. For example, those described as one element may be divided into a plurality of elements different from each other. For example, the order of steps in the flowchart shown in FIG. 3 may be changed, or some of the steps are allowed to be unperformed. For example, various types of information (values, ranges, and the like) may be either set in advance in the computer 20 shown in FIG. 1 or set by being read into the computer 20 from a storage device outside the computer 20. The various types of information may be either directly set by the manual operation of a user or set to the computer 20 based on the information set by the manual operation of the user. For example, the various types of information may be either not changed or changed by a manual operation, and the computer 20 may be automatically changed according to some conditions. For example, the computer 20 may perform substantially the same processing as the processing (calculation, determination, etc.) of the above-described embodiment. For example, numerical formulas, processing procedures, information used for processing, and the like is variously changeable. Specifically, the computer 20 may perform processing using information convertible into various types of information used in the above-described embodiment. The processing performed by the computer 20 may be variously combined. For example, each component may have only a part of each feature (such as an action function, an arrangement, a shape, an operation, and the like).

## Claims

1. A work site simulation system comprising:
a computer that simulates a motion of a work machine at a work site in a virtual space, wherein:
the computer is configured to perform acquiring a site model that is shape information about a shape of the work site, setting an area of a part of the site model as a selection area, and converting the site model into a changeable model in the selection area, the changeable model being shape information that allows change processing to be performed on the changeable model by the computer, the change processing including at least one of deformation, movement, addition, and removal; and
the computer is configured to restrict the change processing on the site model more than the change processing that is allowed to be performed on the changeable model.

2. The work site simulation system according to claim 1, wherein
the computer is configured to prohibit any of the change processing that is allowed to be performed on the changeable model from being performed on the site model.

3. The work site simulation system according to claim 1, wherein the changeable model includes a work object that is an object of work to be performed by the work machine.

4. The work site simulation system according to claim 1, wherein the computer is configured to set the selection area based on a range within which the work machine is operable.

5. The work site simulation system according to claim 1, wherein the computer is configured to set the selection area based on a numerical value that is input to the computer.

6. The work site simulation system according to claim 1, further comprising a display unit, wherein the computer is configured to make the display unit display an area change part to which an operation for changing a selection area attribute including at least one of a position, a shape, and a size of the selection area can be applied, and the computer is configured to change the selection area attribute in accordance with the operation applied to the area change part.

7. The work site simulation system according to claim 1, wherein the computer is configured to set a part of an area of the changeable model as a physical calculation area, the physical calculation area being an area in which calculation for making an object included in the changeable model perform a movement corresponding to a physical phenomenon is allowed to be performed by the computer.

8. The work site simulation system according to claim 7, wherein the computer is configured to set the physical calculation area based on a position of the work machine at the work site.

9. The work site simulation system according to claim 1, further comprising an output unit capable of outputting information, wherein the computer is configured to make the output unit output a notification when a notification target site included in the work machine deviates from an area of the changeable model.

10. The work site simulation system according to claim 1, wherein the computer is configured to bring an object included in the changeable model into a predetermined state that is determined in advance.

11. The work site simulation system according to claim 10, wherein the computer is configured to bring a ground surface included in the changeable model into the predetermined state.

12. The work site simulation system according to claim 1, wherein the changeable model includes an object-in-container that is an object contained in a container.

13. The work site simulation system according to claim 12, wherein the computer is configured to bring the object-in-container into a predetermined state that is determined in advance.

14. The work site simulation system according to claim 12, wherein the computer is configured to calculate an amount of the object-in-container.

15. The work site simulation system according to claim 3, wherein
the work site simulation system, wherein the computer is configured to calculate a change amount of an amount of the work object in a calculation target area set in the changeable model.

16. The work site simulation system according to claim 3, wherein
the computer is configured to perform setting an object addition area in the changeable model, determining an amount of the work object, and adding the determined amount of the work object in the object addition area of the changeable model.

17. The work site simulation system according to claim 3, wherein
the computer is configured to perform setting an object removal area in the changeable model and removing the work object that is predetermined from the object removal area.

18. The work site simulation system according to claim 1, further comprising a display unit capable of displaying information, wherein the changeable model includes deformable sediment, and the computer is configured to make the output unit display a surface of the deformed sediment in a mode different from a mode of a display of a surface of the undeformed sediment.

19. The work site simulation system according to claim 1, wherein the computer is configured to perform setting two or more interaction objects including a behavior simulation target object in the virtual space and simulating a behavior of the behavior simulation target object associated with an interaction between the interaction objects, the behavior of the behavior simulation target object including at least one of deformation and movement of the behavior simulation target object.

20. The work site simulation system according to claim 19, wherein the behavior simulation target object includes sediment.

21. The work site simulation system according to claim 19, wherein the behavior simulation target object includes a ground surface.

22. The work site simulation system according to claim 19, wherein the behavior simulation target object includes a ground surface and an object at a position separated from the ground surface.

23. The work site simulation system according to claim 19, wherein the behavior simulation target object includes an object-in-container that is an object contained in a container.

24. The work site simulation system according to claim 19, wherein the behavior simulation target object includes a work object that is an object of work to be performed by a work device included in the work machine.

25. The work site simulation system according to claim 24, wherein the interaction object includes the work object and the work device that is included in the work machine and performs work on the work object as a target.

26. The work site simulation system according to claim 19, wherein the computer is configured to simulate a deformation of the behavior simulation target object, the deformation involving a movement of the behavior simulation target object.

27. The work site simulation system according to claim 19, wherein the computer is configured to simulate the behavior simulation target object that is particulate.

28. The work site simulation system according to claim 26, wherein the behavior simulation target object includes a work object that is an object of work to be performed by a work device included in the work machine, and the computer is configured to determine a behavior of the particulate work object based on a physical quantity related to the work object.

29. The work site simulation system according to claim 28, wherein the physical quantity includes at least one of an amount by which the work object is moved by the work device, a relative position of the work device to the work object, and a force applied to the work object by the work device.

30. The work site simulation system according to claim 29, wherein the work object included in the behavior simulation target object includes sediment in a bucket included in the work device of the work machine, and the physical quantity includes at least one of a change amount of an amount of the sediment in the bucket, an amount by which the sediment is moved by the bucket, a relative position of the bucket to the sediment, and a pressing force applied to the sediment by the bucket.
